(19) **Europäisches Patentamt European Patent Office Office européen des brevets**

(11) **EP 1 021 885 B1**

(12) **EUROPEAN PATENT SPECIFICATION**

(45) Date of publication and mention
of the grant of the patent:
**12.12.2007 Bulletin 2007/50**

(51) Int Cl.:
***H04L 7/04*** (2006.01)

(21) Application number: **98951028.4**

(86) International application number:
**PCT/US1998/021377**

(22) Date of filing: **08.10.1998**

(87) International publication number:
**WO 1999/018691 (15.04.1999 Gazette 1999/15)**

(54) **DIGITAL PHASE DISCRIMINATION BASED ON FREQUENCY SAMPLING**

DIGITALER PHASENDISKRIMINATOR BASIERT AUF FREQUENZABTASTUNG

DISCRIMINATION DE PHASE NUMERIQUE DEPENDANT D'UN ECHANTILLONNAGE DE FREQUENCES

(84) Designated Contracting States:
**AT BE CH CY DE DK ES FI FR GB GR IE IT LI LU MC NL PT SE**
Designated Extension States:
**AL LT LV MK RO SI**

(30) Priority: **08.10.1997 US 947027**
**14.01.1998 US 6938**

(43) Date of publication of application:
**26.07.2000 Bulletin 2000/30**

(60) Divisional application:
**07018672.1**

(73) Proprietor: **Matsushita Electric Industrial Co., Ltd.**
**Kadoma-shi**
**Osaka 571-8501 (JP)**

(72) Inventor: **SANDER, Wendell**
**Los Gatos, CA 95032 (US)**

(74) Representative: **Gassner, Wolfgang**
**Patentanwälte**
**Dr. Gassner & Partner**
**Marie-Curie-Strasse 1**
**91052 Erlangen (DE)**

(56) References cited:
| | |
|---|---|
| **US-A- 4 468 794** | **US-A- 4 527 145** |
| **US-A- 4 764 923** | **US-A- 5 513 209** |
| **US-A- 5 557 647** | **US-A- 5 664 165** |
| **US-A- 5 703 502** | |

**Description**

BACKGROUND OF THE INVENTION

**Field of the Invention**

The present invention relates to digital phase discrimination.

**State of the Art**

Phase discrimination is important in digital radio communications, in particular in any angle modulation digital radio receiver. Phase discrimination and frequency discrimination are closely related, Frequency discrimination is typically performed using analog circuitry, e.g. an IQ frequency discriminator. Analog frequency discriminators have substantial drawbacks. In the case of an IQ frequency discriminator, the discriminator requires a number of analog components, two A/D conversions and a numerical arctangent operation, rendering the circuit quite complex.

Known methods exist for producing a value representing the instantaneous phase of a signal using only digital logic elements. Various such methods are described in U.S. Patent 5,084,669. In particular, the foregoing patent describes a digital circuit for determining the instantaneous phase of a signal, from which the instantaneous frequency may be obtained if desired. Although the implementation of the circuit is all digital, it is quite involved. An improved method and apparatus for determining in a simple, all-digital manner the instantaneous phase of a signal would therefore likely be well-received by those skilled in the art.

US patent N°5 664 165 discloses a system that generates a synthetic clock signal in synchronism with both a high frequency clock signal and low frequency clock signal, where the rising and falling edges of the low frequency clock signal are subject to material skew. The frequency ratio between the high and low frequency clock signal is derived by sampling the low frequency clock signal at the frequency of the high frequency clock signal. The synthesized low frequency clock signal is generated directly from the high frequency clock signal using the determined relative frequency ratio. The synthetic clock signal is also in synchronism with the low frequency clock signal. Since the synthetic clock signal is derived directly from the high frequency clock signal, it is not subject to the skew problems of the low frequency clock signal.

US patent N°5 557 647 discloses a demodulator. In the demodulator, a receive clock reproducer reproduces a receive clock based on a received baseband signal and a phase error data generates phase error data indicative of a phase error between the reproduced receive clock and a system clock for control of an entire receiver. Further, a sampling clock generator changes a phase of the system clock based on the phase error data to generate an optimum sampling clock to the baseband signal and receive data generator generates receive data corresponding to the baseband signal sampled at its optimum positions based on the optimum sampling clock. Thereafter, a data timing adjustor adjusts synchronization of the receive data with the system clock based on the phase error data. Alternatively, a filter coefficient of the filter associated with the phase error between the system clock and the reproduced receive clock to control the phase of the received baseband signal, whereby the baseband signal for a plurality of time slots is synchronized with the single system clock. Thus, demodulation of the baseband signal having different phase errors for the plurality of time slots can be processed by using a single system clock.

SUMMARY OF THE INVENTION

The present invention, generally speaking, provides a simple, all-digital method and apparatus for determining the phase of a first clock signal relative to a second clock signal. The first clock signal may be a digital approximation of a periodic analog signal such as an RF signal. A sampling technique is employed that produces a stream of digital bits containing relative phase information. From the stream of digital bits is formed a digital word indicative of the relative phase. The digital word may be formed using a digital filter. Advantageously, an extensive body of digital filtering techniques applicable to Sigma-Delta (sometimes referred to as Delta-Sigma) A/D converters may be applied directly to the digital stream. By using an appropriately-chosen weighting function, high accuracy may be obtained.

In accordance with another aspect of the invention, a method of determining a ratio of frequencies of a first clock signal and a second clock signal is provided. The first clock signal is sampled in accordance with the second clock signal to produce a stream of digital bits or symbols, and from the stream of digital bits or symbols a digital word is formed indicative of the ratio of frequencies. The digital word may be formed by filtering the stream of digital bits or symbols. Apparatus for practicing the foregoing method may include circuitry for sampling the first clock signal in accordance with the second clock signal to produce a stream of digital bits or symbols and circuitry, such as a digital filter, for forming from the stream of digital bits or symbols a digital word indicative of the ratio of frequencies. Preferably, the digital filter employs a weighting function in which different weights are applied to different digital bits or symbols.

In accordance with a related aspect of the invention, a method is provided of producing a data stream indicative of a ratio of frequencies of two clock signals performed by sampling one of the clock signals in accordance with the other clock signal to form a stream of digital bits or symbols, each digital bit or symbol representing a number of transitions of a predetermined polarity of the one clock signal that occurred during a particular period of the other clock signal, such that the stream of digital bits or symbols may be further processed to determined the ratio of frequencies. A circuit for producing such a data stream indicative of a ratio of frequencies of two clock signals may include a first input terminal to which a first clock signal is applied, a second input terminal to which a second clock signal is applied, the circuit producing as an output signal a stream of digital bits or symbols, each digital bit or symbol representing a number of transitions of a predetermined polarity of the one clock signal that occurred during a particular period of the other clock signal, such that the stream of digital bits or symbols may be further processed to determined the ratio of frequencies.

In accordance with still a further aspect of the invention, an apparatus is provided for generating a Delta/Sigma modulation of the ratio of two frequencies Fx and Fs, including a counter circuit for counting the number of clock edges of Fs occurring in the time period between clock edges of Fx and a register circuit for storing the value of the counter at each clock edge of Fs. The sequence of values from the register means constitutes the Delta/Sigma modulation quantized data.

BRIEF DESCRIPTION OF THE DRAWING

The present invention may be further understood from the following description in conjunction with the appended drawing. In the drawing:

Figure 1 is a block diagram illustrating a sampled-data model of a Sigma-Delta modulator and of a sampling circuit applied to frequency sampling in accordance with one embodiment of the present invention;
Figure 2 is a table helpful in explaining operation of the circuit model of Figure 1 in the instance of an input frequency that is 0.6875 times a reference frequency;
Figure 3 is a timing diagram illustrating the principle of operation of the circuit model of Figure 1 as applied to frequency sampling;
Figure 4 is a schematic diagram of one example of a frequency sampling circuit described by the circuit model of Figure 1;
Figure 5 is a first timing diagram illustrating operation of the frequency sampling circuit of Figure 4;
Figure 6 is a second timing diagram illustrating operation of the frequency sampling circuit of Figure 4;
Figure 7 is a graph of two alternative weighting functions that may be used to perform digital filtering of a digital bit stream produced by a circuit such as that of Figure 4;
Figure 8 is a graph illustrating the accuracy obtained from a digital frequency discriminator using a constant weighting function;
Figure 9 is a graph illustrating the accuracy obtained from a digital frequency discriminator using a triangular weighting function; and
Figure 10 is a block diagram of one example of a digital filter that may be used in conjunction with a frequency sampling circuit such as that of Figure 4.
Figure 11A is a tabulation illustrating one method of digital phase discrimination;
Figure 11B is a plot showing results of the method of Figure 11A;
Figure 11C is a plot of a weighting function used in connection with Figures 11A and 11B;
Figure 12A is a tabulation illustrating another method of digital phase discrimination;
Figure 12B is a plot showing results of the method of Figure 12A;
Figure 12C is a plot of a weighting function used in connection with Figures 12A and 12B;
Figure 13 is a block diagram of digital phase discrimination hardware in accordance with the technique of Figure 12;
Figure 14A is a tabulation illustrating yet another method of digital phase discrimination;
Figure 14B is a plot showing results of the method of Figure 14A;
Figure 14C is a plot of a weighting function used in connection with Figures 14A and 14B;
Figure 15 is a block diagram of digital phase discrimination hardware in accordance with the technique of Figure 14;
Figure 16A is a tabulation illustrating still another method of digital phase discrimination;
Figure 16B is a plot showing results of the method of Figure 16A;
Figure 16C is a plot of a weighting function used in connection with Figures 16A and 16B;
Figure 17 is a block diagram of digital phase discrimination hardware in accordance with the technique of Figure 16.

DETAILED DESCRIPTION OF THE PREFERRED EMBODIMENTS

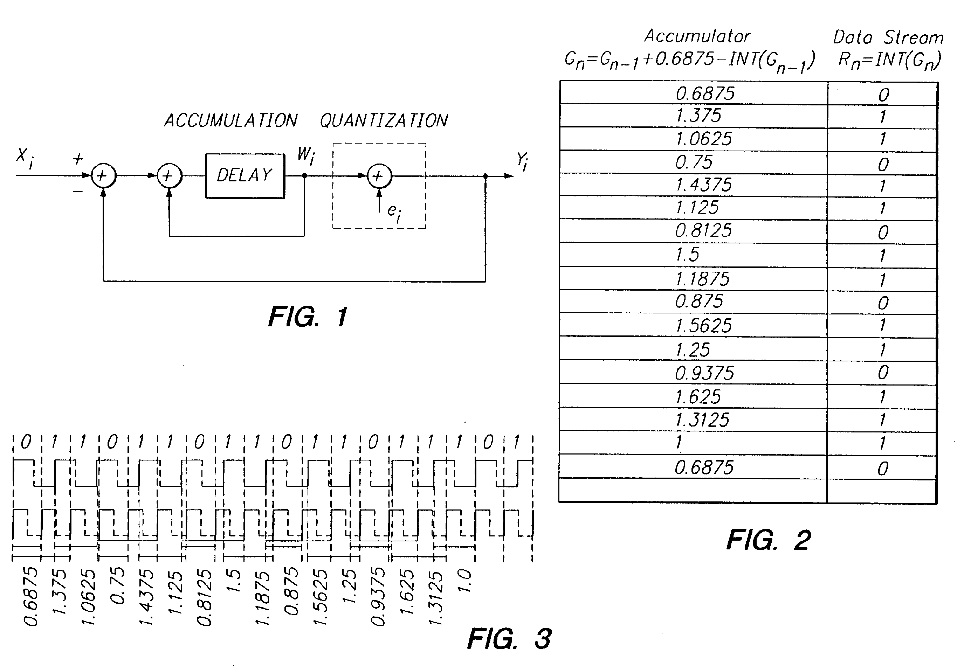

The approach followed by the digital frequency discriminator of the present invention may be appreciated by analogy to Sigma-Delta A/D conversion, well-documented in the prior art by such references as "Oversampling Delta-Sigma Data Converters", Candy, et al., IEEE Press, pages 1-6, Piscataway, NJ (1992). A Sigma-Delta converter modulates a varying-amplitude analog input signal into a simple digital code at a frequency much higher than the Nyquist rate. The design of the modulator allows resolution in time to be traded for resolution in amplitude. A sampled-data circuit model of a Sigma-Delta modulator, shown in Figure 1, may be directly applied to frequency sampling as described herein.

Referring to Figure 1, an input signal $x_i$ occurring at sample time i has subtracted from it the output signal $y_i$ at sample time i. The result is applied to an accumulator having an output signal $w_i$. A "new" input signal of the accumulator at sample time i is combined with the "old" output signal of the accumulator to form a new output signal of the accumulator. The output signal of the accumulator is quantized, the quantization being represented as the addition of an error $e_i$. The output signal of the quantizer is the final output signal $y_i$.

Assume now that $x_i$ is the ratio of two frequencies and that the quantizer is a two-level quantizer. Further assume that the ratio of the two frequencies for the time period in question is, say, 0.6875. As shown in Figure 2, the latter value is accumulated a first time, giving an accumulated value of 0.6875. This valuing being less than 1, the value 0.6875 is again added to the accumulated value, giving a new accumulated value of 1.375. Since this value is now greater than 1, 1 is subtracted from 0.6875 and the result (0.6875 - 1 = -0.3125) added to the accumulator to give a value of 1.0625. Operation proceeds in this fashion. During the foregoing sequence of operations, a data stream is produced by taking the integer portion, 1 or 0, of each accumulated value.

Referring to Figure 3, the interpretation of the sequence of numbers shown in Figure 2 may be appreciated. Two clock signals are shown. Again, it is assumed that the ratio of the frequency of the upper clock signal to that of the lower clock signal during the period of interest is 0.6875. At time t = 0, rising edges of both clock signals coincide. At the first subsequent rising edge of the lower clock signal, 0.6875 periods of the upper clock signal have elapsed. At the next rising edge of the lower clock signal, 1.375 periods of the upper clock signal have elapsed. At the next rising edge of the lower clock signal, 1.0625 periods of the upper clock signal have elapsed since the elapse of the first period of the upper clock signal, and so on.

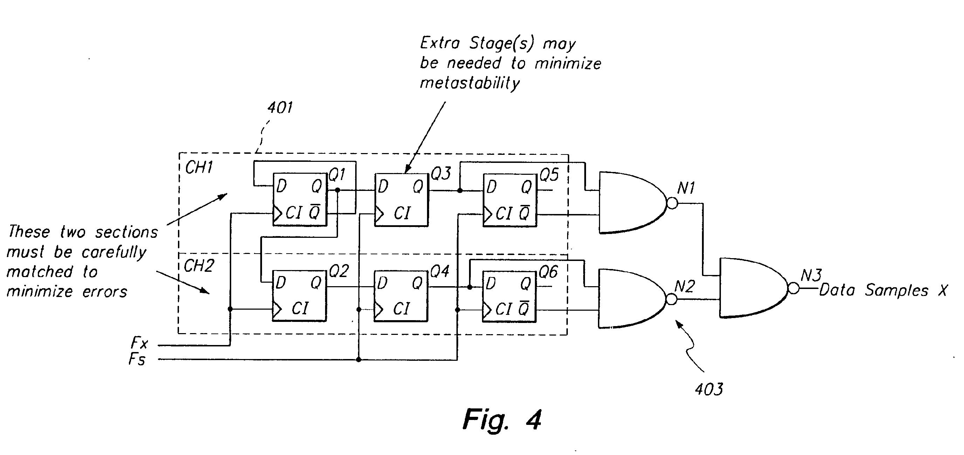

A schematic diagram of a capture circuit, or frequency sampling circuit, that may be used to data samples corresponding to the data stream described in the foregoing example is shown in Figure 4. In the illustrated embodiment, it is assumed that the ratio of the clock signals is such that no more than one rising edge of the faster clock will occur during a single period of the slower clock. In other embodiments, this assumption need not apply.

The capture circuit includes a input portion 401 and an output portion 403. The input portion includes two sections Ch1 and Ch2 that must be carefully matched to minimize errors. Each section comprises a chain of two or more D flip-flops coupled in series. In the following description, the same reference numerals will be used to reference the respective flip-flops themselves and their respective output signals.

Within each section, the first flip-flop in the chain is clocked by a sampled clock signal Fx. The succeeding flip-flops in the chain are clocked by a sampling clock signal Fs. The D input of the first flip-flop Q1 in the upper section is coupled to the $\overline{Q}$ output of the same. The D input of the first flip-flop in the lower section is coupled to the Q output of the first flip-flop in the upper section. The remaining flip-flops in both sections are coupled in series--i.e., Q to D, Q to D.

The function of the input portion is to 1) produce two signals, logical inverses of one another, that transition on rising edges of the clock signal Fx; 2) to latch the values of the two signals on the rising edge of the clock signal Fs; and 3) to detect transitions from one clock to the next. Additional intermediate stages in series with Q3 and Q4 may be required to minimize metastability resulting from the asynchrony of the two clock signals, and in fact multiple such stages may be desirable in a particular design.

The output portions include, in an exemplary embodiment, three two-input NAND gates. Respective NAND gates N1 and N2 are coupled to the D and $\overline{Q}$ signal of the final flip-flop stages of the input sections. Output signals of the NAND gates N1 and N2 are combined in the further NAND gate N3 to form the final output of the capture circuit.

The function of the output portion is to detect a change in the input clock signal level from one sample clock to the next in either of two channels formed by the two input sections. The two input sections function in a ping-pong fashion, alternately detecting changes in the input clock signal level.

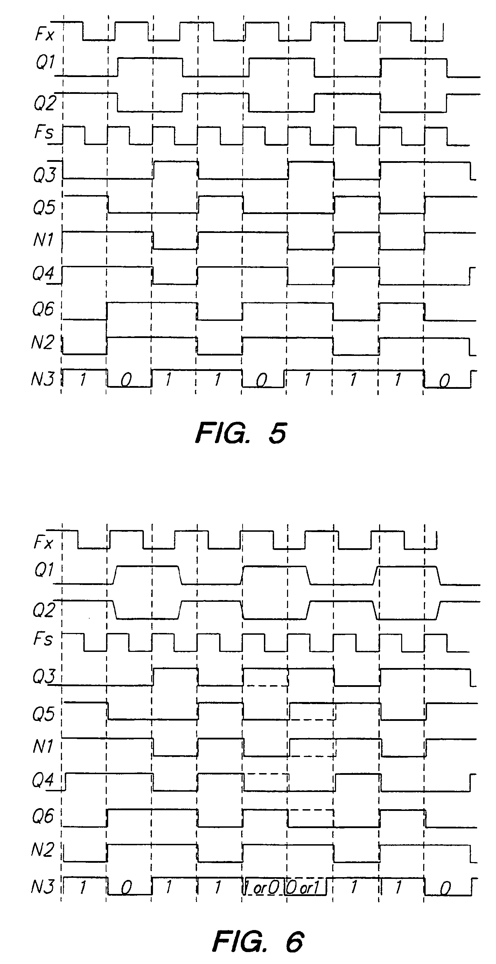

Operation of the capture circuit of Figure 4 may be more fully appreciated with reference to the timing diagram of Figure 5. The first stages of the two channels form inverse signals Q1 and Q2 approximately coincident with (but slightly delayed from) rising edges of the input clock signal. The signals Q3 and Q4 are formed by sampling the signals Q1 and Q2, respectively, in accordance with the sample clock. The signals Q5 and Q6, respectively, are delayed replicas of the signals Q3 and Q4. The NAND gates together realize the logic function $X = Q3 \cdot \overline{Q5} \lor Q4 \cdot \overline{Q6}$.

In the example of Figure 5, the illustrated signals are all idealized square-wave signals. In actuality, the signals will have finite rise and fall times. The possible effect of the finite rise and fall times of the signals Q1 and Q2 and the asynchrony of the circuit is metastability, as illustrated in Figure 6. Here, the signals Q3 and Q5 and the signals Q4 and Q6 are each in an indeterminate state for one cycle. The resulting output of the circuit may or may not be correct. However, because the decision was a "close call" to begin with, the effect of an occasional erroneous decision on the overall operation of the circuit is negligible. The time window of instability is reduced by increasing the overall gain in the path. If the gain in Q3 and Q9 is sufficient to reduce the probability of an error to an acceptable level, then no additional circuitry is required. If not, then additional circuitry will be required to increase the gain.

In order to recover the ratio of the frequencies of the two clock signals from the data stream produced by a capture circuit such as the one of Figure 4, digital filtering is applied. Advantageously, an extensive body of digital filtering techniques applicable to Sigma-Delta (or Delta-Sigma) A/D converters may be applied directly to the digital stream. Furthermore, by using an appropriately-chosen weighting function, high accuracy may be obtained.

The weighted sum of products is an example of an FIR filter. The weighting function described heretofore is therefore that of an FIR filter in digital filtering theory. It should be recognized, however, that IIR filters can also be used. In the process of FIR digital filtering, the weighting function is applied to a "window" of data samples to obtain an estimate of the ratio of frequencies in the center of the window. The window is then "picked up and moved" to the next sequence of samples. Windowing will typically overlap. A window may include 256 samples, for example.

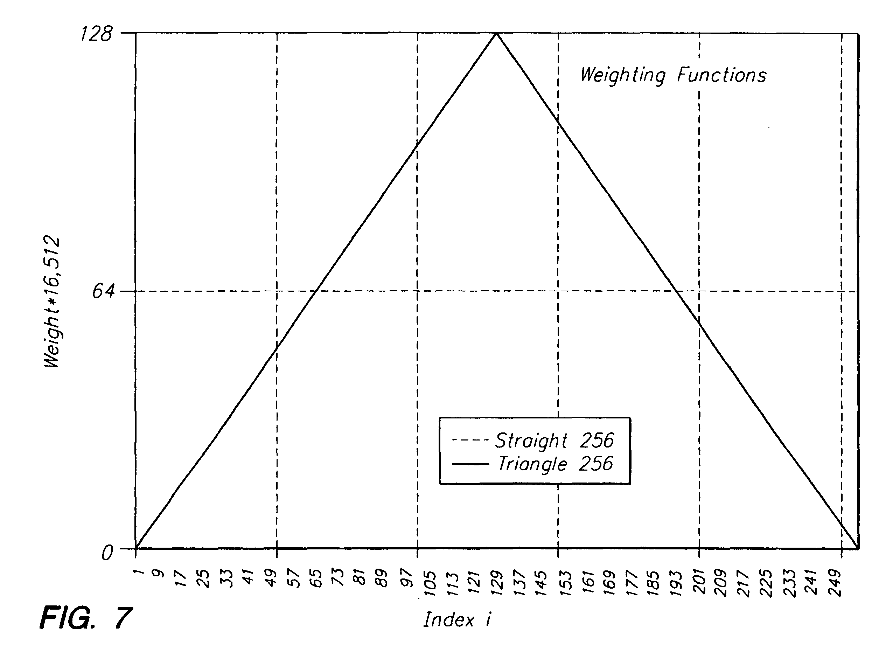

Referring to Figure 7, two alternative weighting functions are shown for a window of 256 samples. The weighting functions are normalized, meaning that the area under the weighting function is unity. One weighting function, indicated in dashed lines, is a straight-line, constant weighting function. Another weighting function, indicated in solid line, is a triangular weighting function. The weighting function is the impulse response function in digital filters.

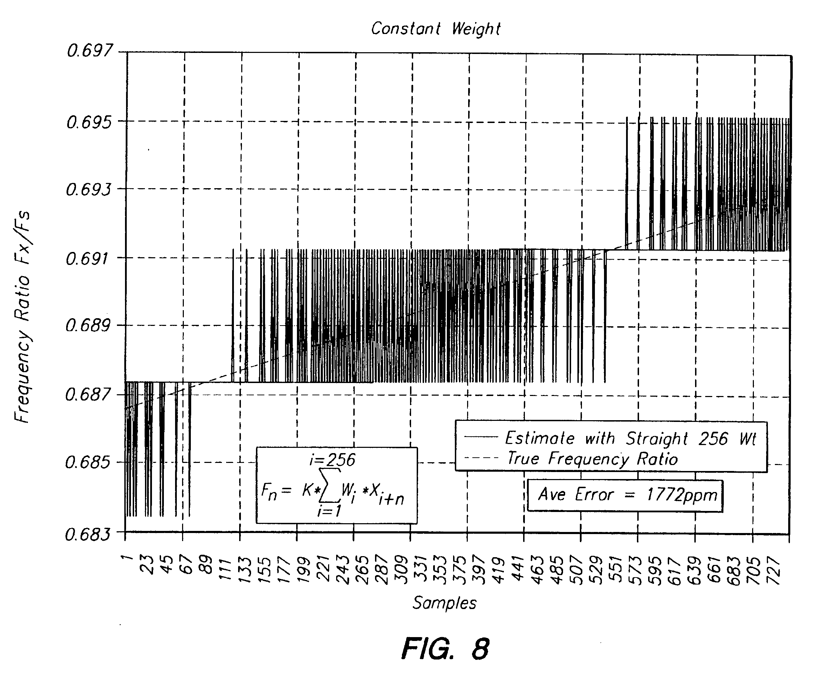

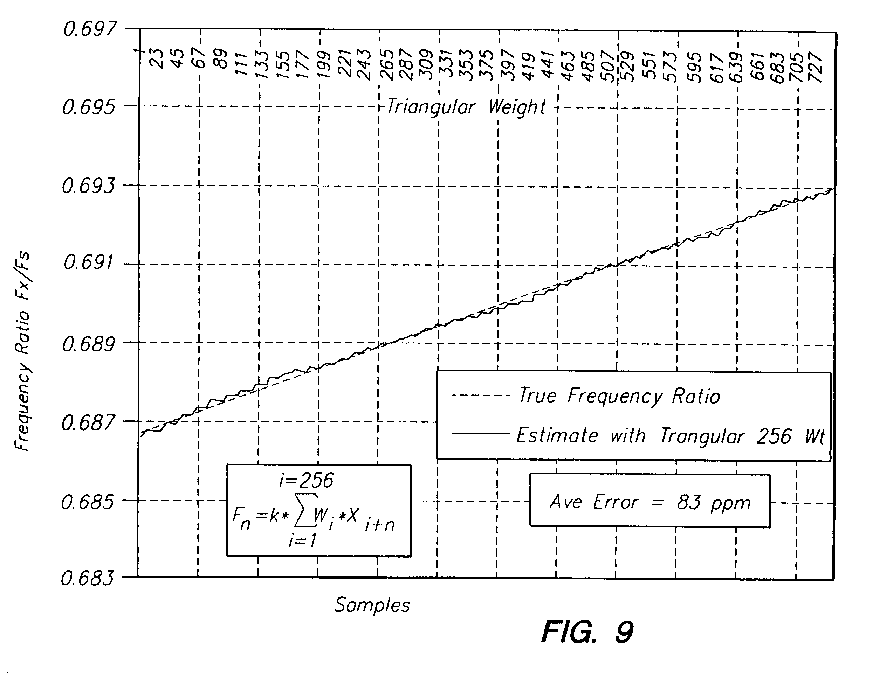

Results of digital filtering using the straight-line weighting function and the triangular weighting function respectively, are shown in Figure 8 and Figure 9. In the case of both Figure 8 and Figure 9, the frequency ratio was increased from just under 0.687 to just over 0.693. As seen in Figure 8, using a straight-line weighting function, the quantized signal oscillates between two levels that are adjacent to the input in such a manner that its local average equals the average input. The average error was calculated to be 1772ppm. As seen in Figure 9, using a triangular weighting function, the quantized signal tracks the input with an average error of 83ppm.

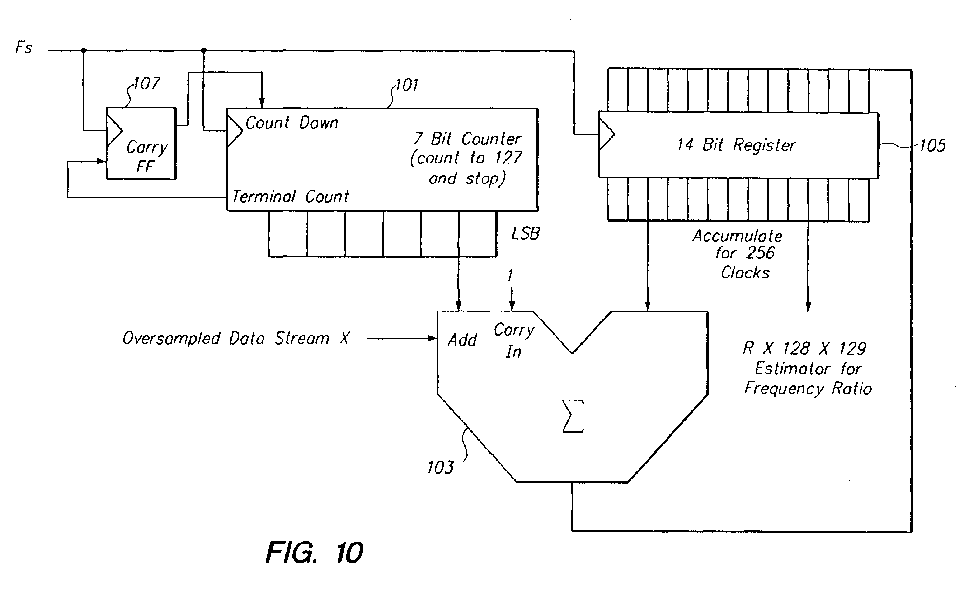

A schematic diagram of an exemplary frequency accumulator that applies a triangular weighting function and that may be used to accomplish the desired digital filtering is shown in Figure 10. In the example shown, the frequency accumulator uses a 7-bit counter 101, a 14-bit adder 103 and a 14-bit register 105. The 7-bit counter is clocked by the sample frequency Fs. The output of the 7-bit counter is provided to one input of the adder. The function of the 7-bit counter is to count up from 0 to 127 and then down from 127 to 0. The count of 127 occurs twice in succession. This behavior is achieved using a flip-flop 107. The flip-flop is clocked by the sample frequency Fs. A Terminal Count signal of the 7-bit adder is input to the flip-flop. The output of the flip-flop is coupled to a Count Down input of the 7-bit counter.

The "oversampled" data stream is coupled to a control input of the adder. When the current bit of the data stream is a 1, an addition is performed. When the current bit is a 0, no addition is performed. A Carry In input of the adder is tied high, effectively causing the range of weights to be 1 to 128.

The 14-bit register is clocked by the sample frequency Fs. Its output is applied to the other input of the adder. Its input receives the output word produced by the adder. The function of the 14-bit adder is to perform an accumulation operation for 256 clocks. At the conclusion of the 256 clocks, the output of the 14-bit adder is used as an estimator for the frequency ratio. More particularly, in the example shown, the output of the accumulator is equal to R x 128 x 129, where R is the frequency ratio estimator.

The foregoing technique may be readily extended to phase discrimination. Various different methods and apparatus for digital phase discrimination will be described entailing different design tradeoffs.

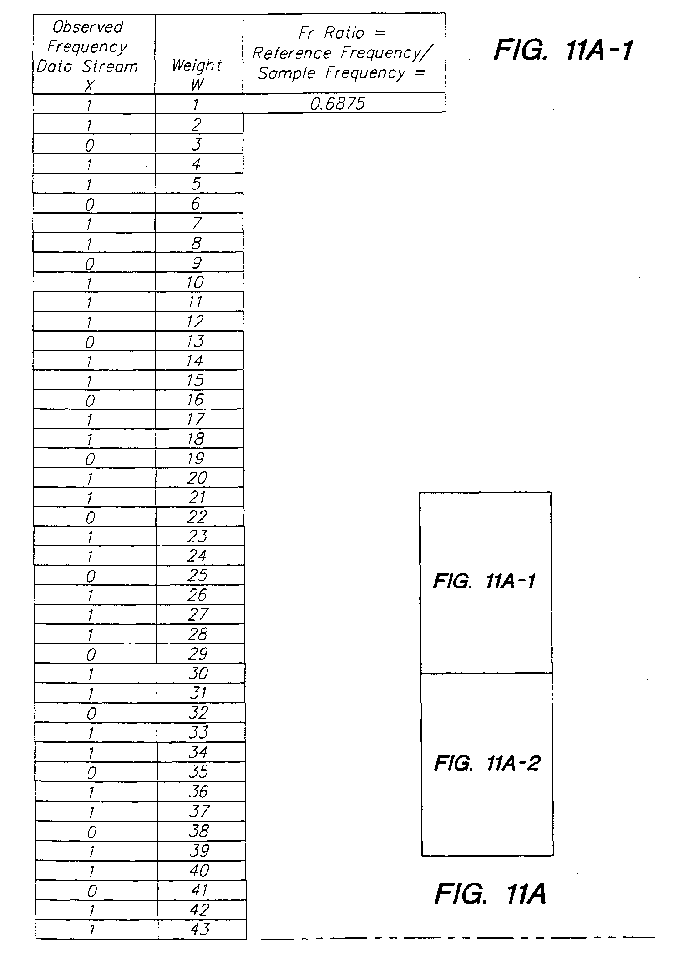

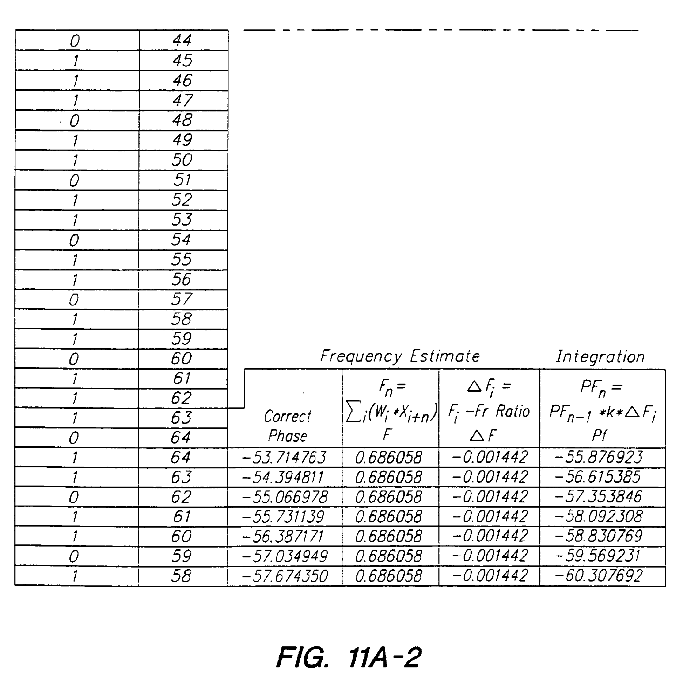

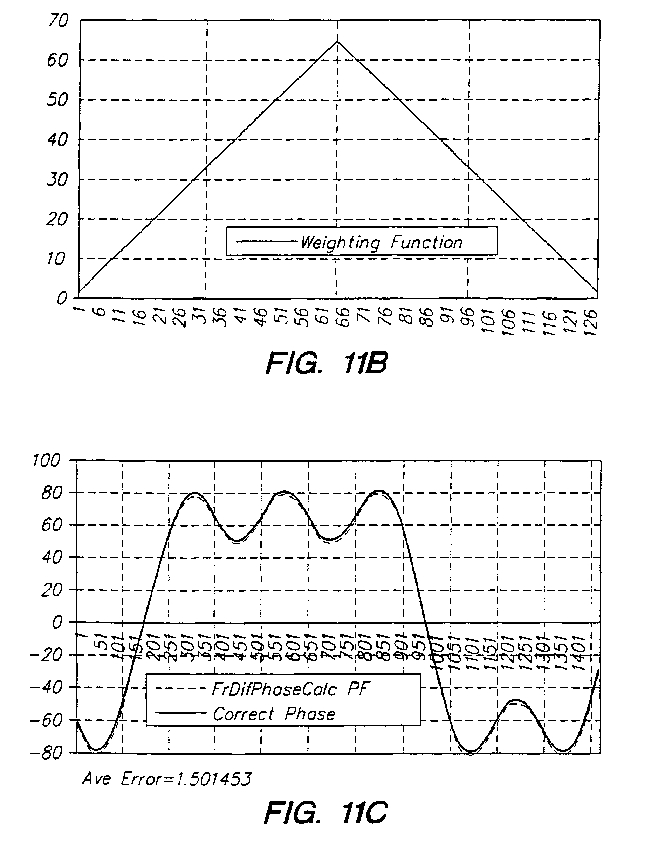

The first method is conceptually straightforward but computationally expensive. Referring to Figure 11A, the same observed frequency data stream and the same set of weights corresponding to a triangular weighting function (Fig. 11B) are used. The ratio of the reference frequency to the sampled frequency over a relatively long period of time is first determined using the technique described previously. Having obtained this frequency ratio estimator, short-term frequency deviations are estimated by calculating the same frequency estimate as before but at a relatively high rate, as often as once per sample period. That is, successive samples are all taken using the circuit of Figure 10, as often as each sample period. The difference ($\Delta F$) of each frequency estimate (F) from the previously-determined frequency ratio (Fr) is calculated, multiplied by an appropriate scale factor k and accumulated to obtain a corresponding phase estimate Pf. (The first value of Pf is an arbitrarily chosen initial condition, chosen for comparison to an ideal estimate. In practice, the phase may be initialized to a value based on a priori knowledge of signal characteristics, or, absent such *a priori* knowledge, may be set to zero upon detection of a phase inflection point.)

A phase-plot simulation comparing actual phase of a specified waveform (solid-line) with estimated phase using the foregoing phase estimation method (dashed-line) is shown in Fig. 11C.

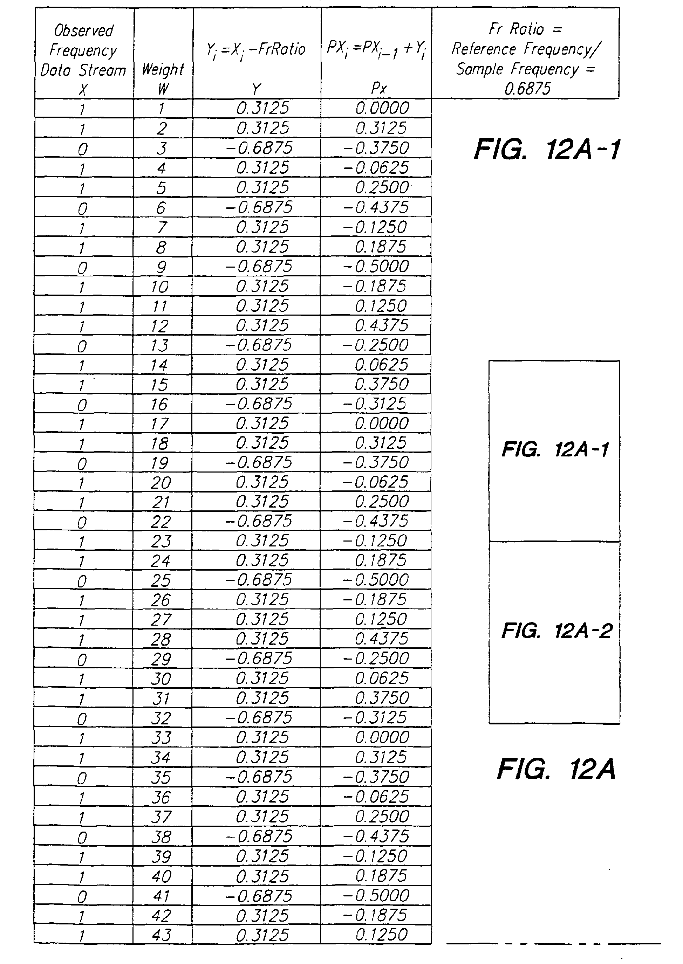

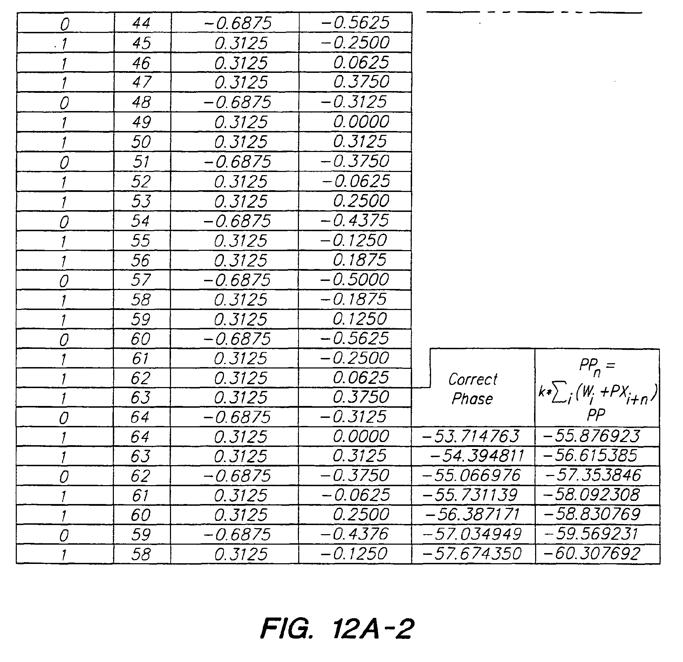

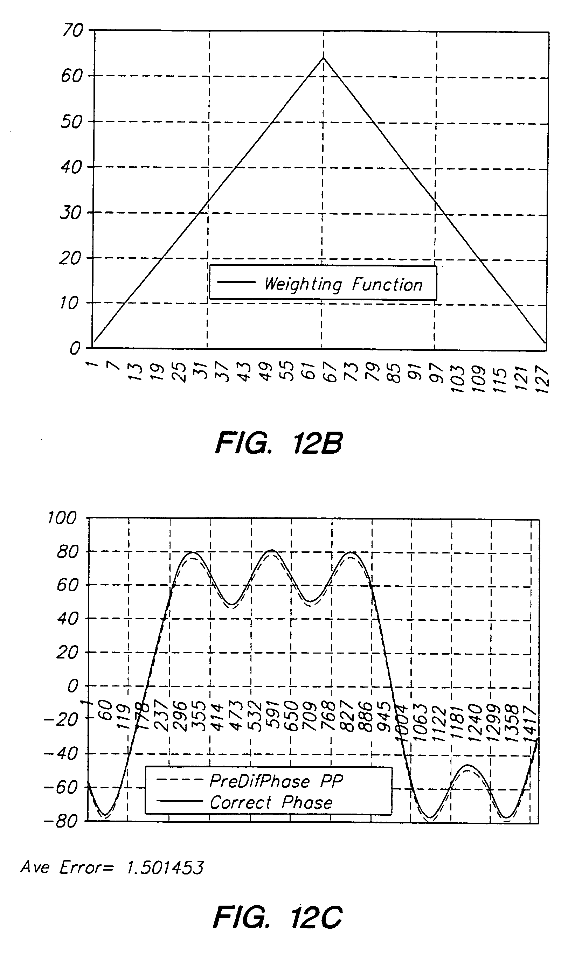

The foregoing "frequency difference" phase estimation method is computationally expensive because of the need to calculate frequency estimates at a relatively high rate. A "pre-summation difference" phase estimation method obviates this requirement. Referring to Figure 12A, instead of subtracting the frequency ratio from a frequency estimate, the frequency ratio Fr is subtracted from the sampled data stream itself. Assuming that the data stream is a bit stream of ones and zeros only, and assuming a frequency ratio Fr = 0.6875, then the pre-summation difference Y will have one of only two values, Y = 1 - 0.6875 = .3125 or Y = 0 - 0.6875 = - 0.6875. The Y values are accumulated to obtain corresponding values PX. Phase estimates $PP_n$ are obtained by filtering the PX values in substantially the same manner as described previously in relation to forming frequency estimates (using the identical weighting function, Fig. 12B, for example) with the exception that the filtered values are scaled by the scale-factor k.

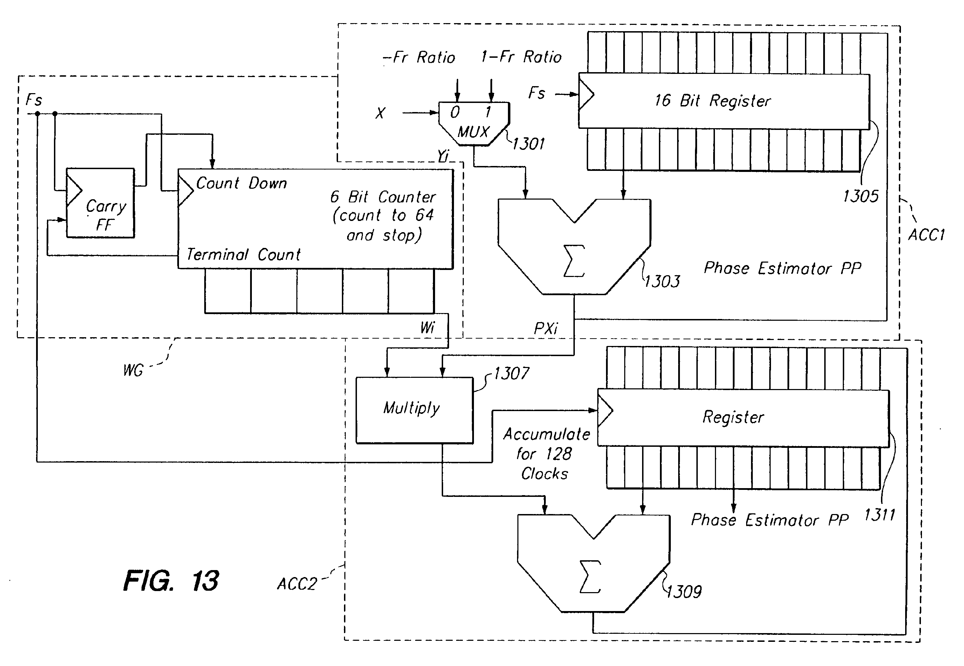

The pre-summation difference phase-calculation may be shown to be mathematically equivalent to the frequency difference phase calculation. Simulation results, shown in Fig. 12C, are therefore the same as in Fig. 11C. The hardware realization, however, may be considerably simpler using the pre-summation difference phase calculation, since only one computation is required per phase point. Such a hardware realization is shown in Figure 13.

The pre-summation difference phase estimator of Figure 13 includes generally a first accumulator ACC1, a weight generator WG similar or identical to the weight generator previously described in relation to Figure 10, and a second accumulator ACC2.

The accumulator ACC1 functions to produce phase numbers $PX_i$ in correspondence to bits (or in other embodiments, symbols) of the observed frequency data stream and includes a multiplexer 1301, an adder 1303 and a register (e.g., a 16-bit register) 1305. The multiplexer 1301 selects one of the two possible values of $Y_i$ in accordance with the value of X and applies $Y_i$ to the adder 1303. The register value is added to $Y_i$ to form $PX_i$, which is then strobed into the register. The adder 1303 and register 1305 therefore accumulate the $PX_i$ values.

The $PX_i$ values are then filtered in the accumulator ACC2, which includes a multiplier 1307, an adder 1309 and a register 1311. The multiplier receives weights from the weight generator WG and $PX_i$ values from the accumulator ACC1. Respective weights and $PX_i$ values are multiplied and the products accumulated, e.g., for 128 clock cycles, to produce a phase estimator PP. The multiplier may be constructed so as to apply the scale factor k to each product during the accumulation process.

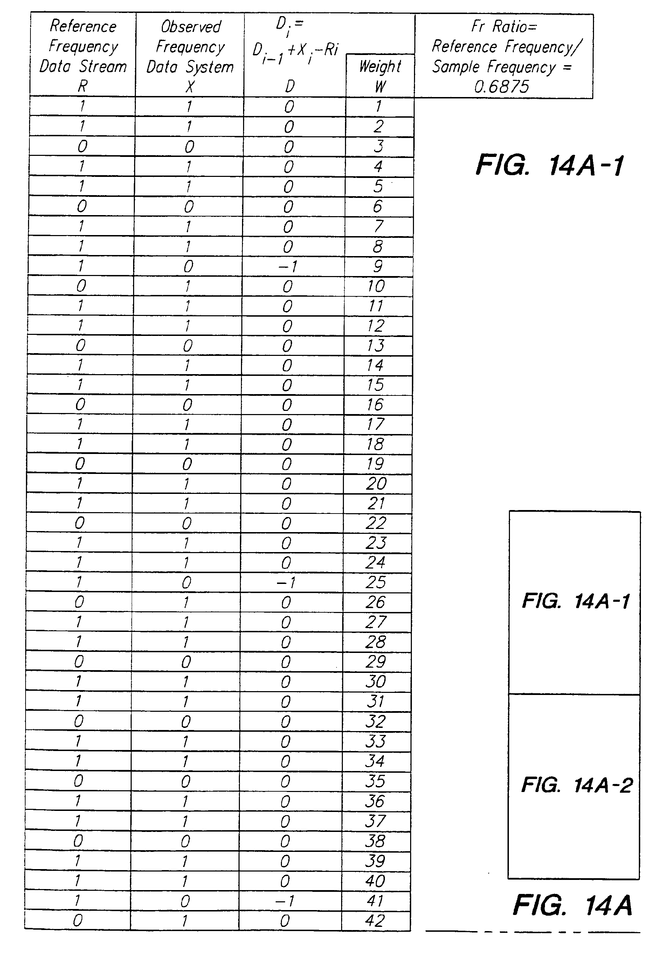

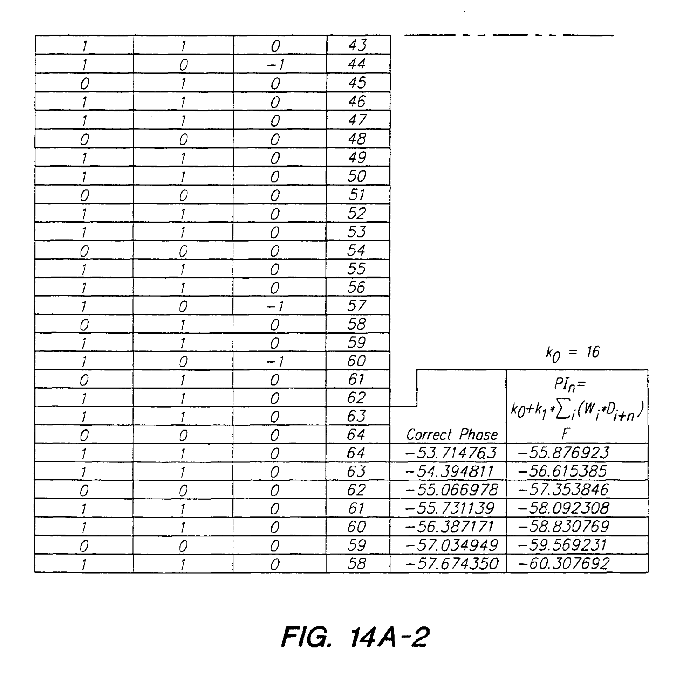

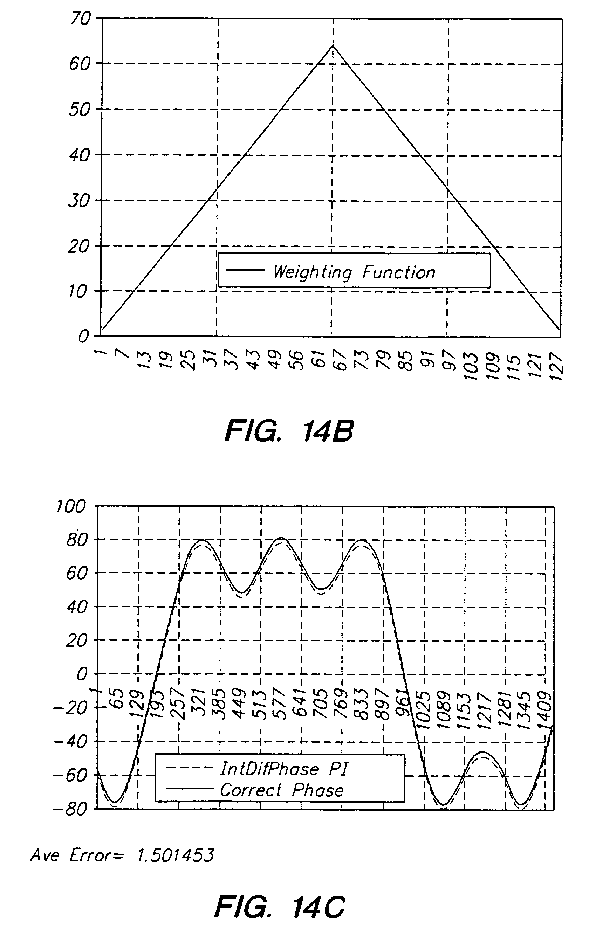

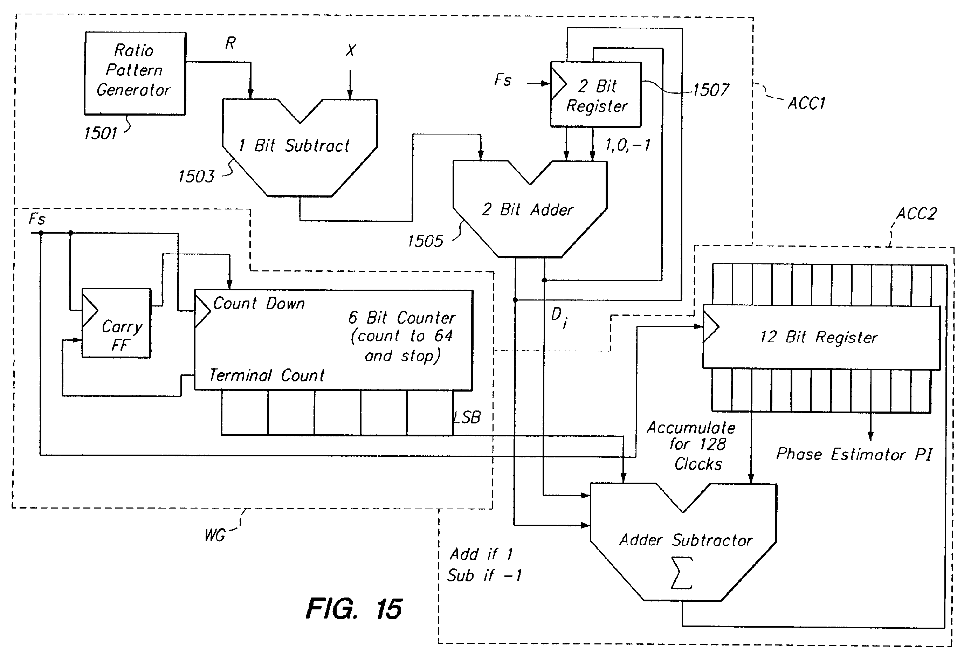

An even simpler realization may be achieved using an integer difference phase calculation. The integer difference phase calculation is not mathematically equivalent to the foregoing methods, but is very close. Referring to Fig. 14A, this method uses, in addition to the observed frequency data stream, a reference frequency data stream that would result if the reference frequency were applied to the capture circuit of Figure 4 (with the same clock). A running sum $D_i$ is then formed of the integer difference $X_i-R_i$. In many practical applications, such as the one illustrated in Figures 14 and 15, $D_i$ will have the values 1, 0 and -1 exclusively. The general case in which $D_i$ takes on other values may be appreciated and understood, however, from the present example, and is embraced by the present description.

Phase estimates are formed by filtering the $D_i$ values in the same or similar manner as previously described. The same triangular weighting function may be used Fig. 14B. The integer difference phase calculation method produces identical simulation results, Fig. 14C, as the preceding methods.

Referring to Figure 15, in the instance where D takes on the values 1, 0 and -1 exclusively, the corresponding hardware realization may be substantially simplified (as compared to that of Figure 13, for example).

The integer difference phase estimator of Fig. 15, like that of Fig. 13, includes generally a first accumulator ACC1, a weight generator WG, and a second accumulator ACC2. The accumulator ACC1 is of considerably different construction than the corresponding structure of Figure 13. The accumulator ACC1 of Figure 15 includes a reference pattern generator 1501, a 1-bit subtractor 1503, a 2-bit adder 1505 and a 2-bit register 1507. The 1-bit subtractor subtracts respective R values from respective X values. The 2-bit adder and the register accumulate the resulting $D_i$ values which, as explained previously, may be constrained to 1, 0, -1 only.

The weight generator WG and the accumulator ACC2 are substantially the same as in Figure 13, described previously. However, because $D_i$ takes on the values 1, 0 and -1 exclusively, no multiplier is required. Instead, if $D_i = 1$, the weight value is added to the accumulated value, and if $D_i = -1$, the weight value is subtracted. (If $D_i = 0$, the accumulated value remains unchanged.) The savings of a hardware multiplier is a particular advantage of the implementation of Fig. 15.

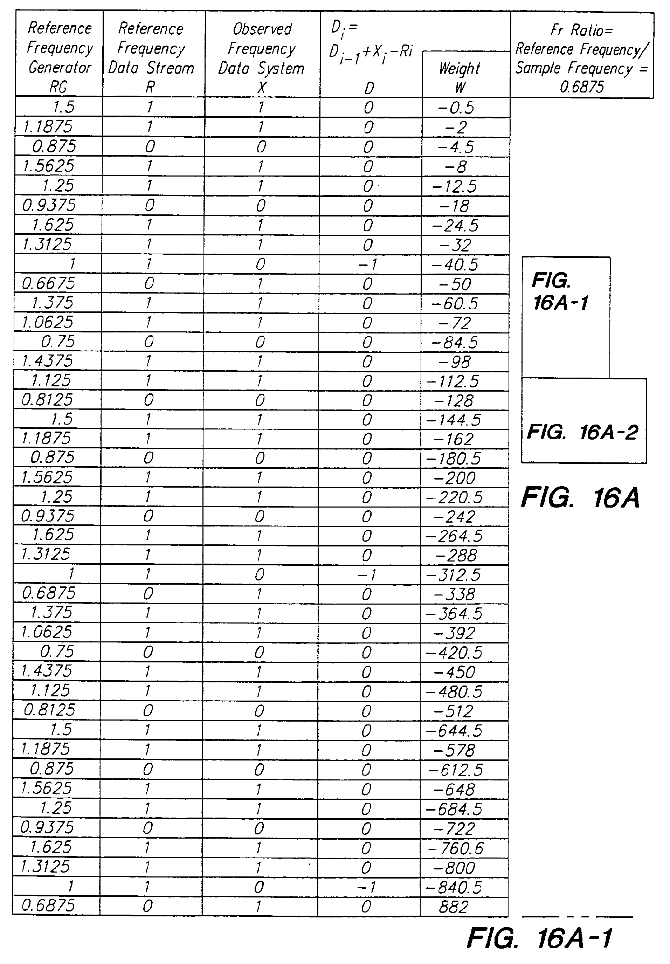

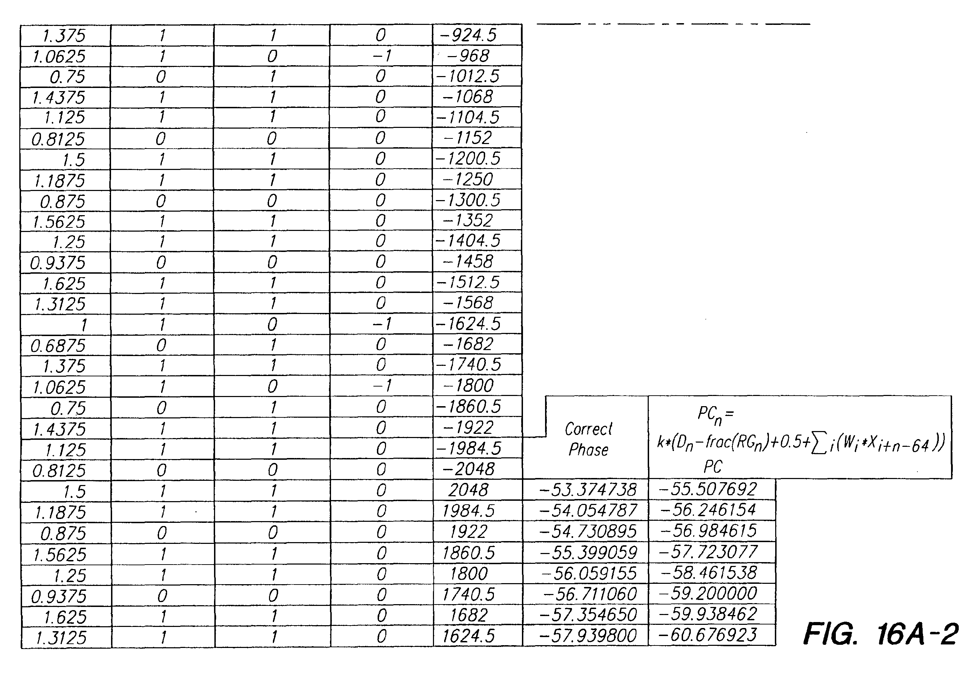

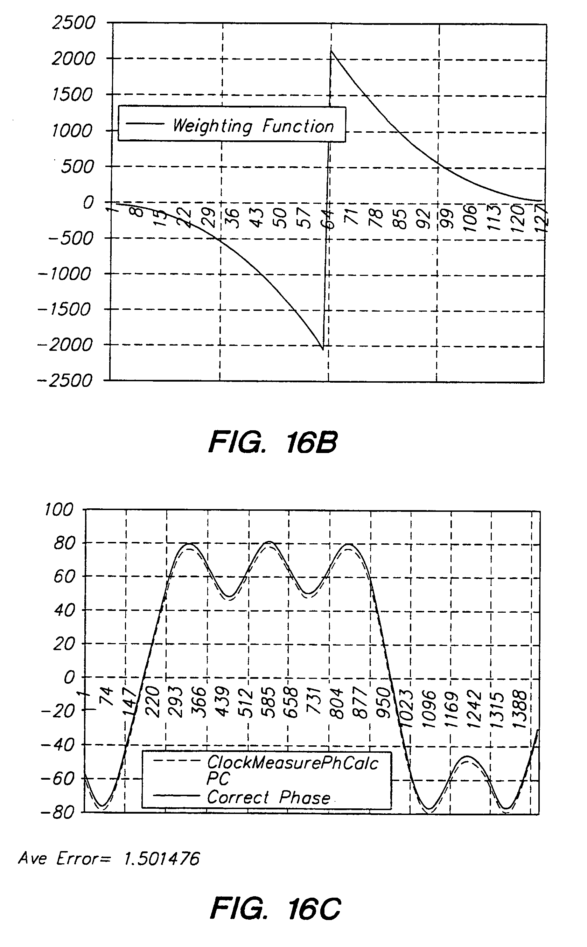

A further method of phase estimation is referred to as the clock measure phase calculation method. Referring to Figure 16A, this method is similar to the previous integer difference phase calculation method insofar as R, X and D are concerned. This method, however, uses in addition to the reference frequency data stream R, "clock measure" numbers RG, which are the same as the numbers appearing in Fig. 2. Moreover, the weight function used is distinctly different, as shown in Figure 16B.

Clock measure phase estimate values PC are obtained using the following formula:

$$PC_n = k \cdot (D_n - \mathrm{frac}(RG_n) + 0.5 + \sum_i (W_i \cdot X_{i-n-64}))$$

Simulation results using the clock measure phase calculation method are shown in Figure 16C.

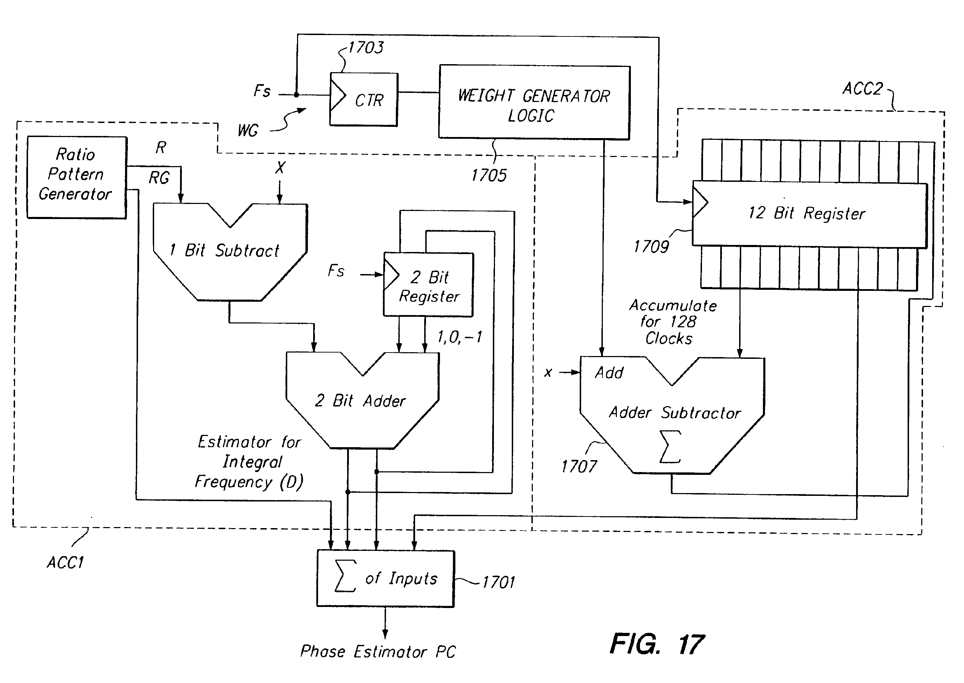

Referring to Figure 17, the clock measure phase estimator includes generally a first accumulator ACC1, a weight generator WG, and a second accumulator ACC2. The estimator additionally includes a summation block 1701.

The accumulator block ACC 1 is substantially the same as the accumulator block ACC1 of Figure 15. Note, however, that the reference pattern generator generates both the reference frequency data stream R, used within the accumulator ACCI, and the clock measure data stream RG which is input to the summation block 1701

The weight generator includes a counter 1703 and weight generator logic 1705. The accumulator ACC2 includes an adder 1707 and a register 1709. When X=1, the weight value from the weight generator is added to the contents of the register 1709. The output of the adder becomes the new input of the register, which performs an accumulator operation for, e.g., 128 clock cycles.

At the conclusion of the accumulation operation of ACC2 the outputs of ACC1 and ACC2, together with the corresponding RG value, are summed in the summation block 1701.

The presently disclosed embodiments of the invention are considered in all respects to be illustrative and not restrictive. The scope of the invention is indicated by the appended claims rather than the foregoing description, and all changes which come within the meaning and range of equivalents thereof are intended to be embraced therein.

**Claims**

1. A circuit for determining a signal indicative of a ratio of frequencies of a first clock signal (Fx) to a reference clock signal (Fs), the reference clock signal (Fs) having a higher frequency than the frequency of first clock signal (Fx), **characterized in that** the circuit comprises:

    an initial storage circuit (Q1) to hold the first clock signal (Fx);
    at least two branches of storage circuits (Q2, Q3, Q4, Q5, Q6) in series with the initial storage circuit (Q1) and operable to hold time-delayed versions of the first clock signal (Fx) and time-delayed versions of the inverse of the first clock signal (Fx), the at least two branches being in parallel with one another;
    a plurality of logic circuits (N1, N2, N3), coupled to the storage circuits, using as input the delayed versions of the first clock signal (Fx) and the delayed inversed versions of the first clock signal (Fx);
    a digital filter coupled to at least one of the plurality of logic circuits (N1, N2, N3), that filters the output of the at least one of the plurality of logic circuits (N1, N2, N3) and operable to output the signal indicative of the ratio of frequencies of the reference clock signal (Fs) to the first clock signal (Fx);
    wherein at least a first storage circuit from amongst the storage circuits, in each of the two branches, is clocked by the reference clock signal (Fs);
    wherein at least a second storage circuit from amongst the storage circuits is clocked by the first clock signal (Fx).

2. The circuit of Claim 1, wherein the digital filter employs a weighting function in which different weights are applied to different outputs at different times of the plurality of logic circuits (N1, N2, N3).

3. The circuit of Claim 1, further comprising:

    a weight generator (WG);
    a first accumulator (ACC1); and
    a second accumulator (ACC2);
    wherein the first accumulator (ACC1) receives as an input a stream of digital bits or symbols associated with the accumulation and quantization output from a first circuit from among the plurality of logic circuits (N1, N2, N3) and produces an output stream of bits or symbols, the weight generator (WG) produces a series of weights, and the second accumulator (ACC2) receives the series of weights and the output stream of bits or symbols from the first accumulator (ACC1) and produces a phase estimate.

4. The circuit of Claim 3, wherein the second accumulator (ACC2) comprises a hardware multiplier.

5. The circuit of Claim 3, wherein said first accumulator (ACC1) comprises a reference pattern generator and said output stream consists of the symbols 1, 0 and -1, and wherein said second accumulator (ACC2) comprises an adder/subtractor.

6. The circuit of Claim 1, further comprising:

    a weight generator (WG);
    a first accumulator (ACC1);
    a second accumulator (ACC2); and
    a summation block;
    wherein the weight generator (WG) produces a series of weights, the first accumulator (ACC1) receives as inputs the stream of digital bits or symbols from a plurality of logic circuits and the series of weights from the weight generator (WG) and produces a first output stream of symbols, the second accumulator (ACC2) receives as inputs the stream of digital bits or symbols from the first accumulator (ACC1) and produces a second output stream of symbols, and the summation block sums outputs from the first accumulator (ACC1) and the second accumulator (ACC2) to produce a phase estimate.

7. A method for determining a signal indicative of a ratio of frequencies of a first clock signal (Fx) to a reference clock signal (Fs), the reference clock signal (Fs) having a higher frequency than the frequency of the first clock signal (Fx), **characterized in that** the method comprises the steps of:

   holding the first clock signal (Fx) in an initial storage circuit (Q1);
   holding time-delayed versions of the first clock signal (Fx) and time-delayed versions of the inverse of the first clock signal (Fx) in at least two branches of storage circuits (Q2, Q3, Q4, Q5, Q6) which are in series with the initial storage circuit (Q1), the at least two branches being in parallel with one another;
   providing a plurality of logic circuits (N1, N2, N3), coupled to the storage circuits (Q1, Q2, Q3, Q4, Q5, Q6), which use as input the delayed versions of the first clock signal (Fx) and the delayed inversed versions of the first clock signal (Fx);
   providing digital filter coupled to at least one of the plurality of logic circuits (N1, N2, N3), that filters the output of the at least one of the plurality of logic circuits (N1, N2, N3) and outputs the signal indicative of the ratio of frequencies of the reference clock signal (Fs) to the first clock signal (Fx);
   clocking at least a first storage circuit from amongst the storage circuits (Q2, Q3, Q4, Q5, Q6), in each of the two branches, by the reference clock signal (Fs); and
   clocking at least a second storage circuit from amongst the storage circuits (Q2, Q3, Q4, Q5, Q6) by the first clock signal (Fx).

8. The method of Claim 7, wherein generating digital data comprises filtering a first stream of digital bits from a first logic circuit (N1) from among the plurality of logic circuits (N1, N2, N3).

9. The method of Claim 8, further comprising calculating a frequency difference phase, the step of calculating further comprising the steps of:

   filtering the first stream to obtain an average ratio of frequencies of the first clock signals;
   filtering the first stream to obtain a series of short-term estimates of the ratio of frequencies of the first clock signals (Fx);
   for each estimate, calculating a difference between the estimate and the average ratio of frequencies and converting the difference to a phase increment; and
   accumulating the phase increments to produce a running phase estimate.

10. The method of Claim 8 or 9, further comprising the steps of:

   producing a second stream of digital bits or symbols that result when the reference clock signals (Fs) is sampled in accordance with the first clock signal (Fx) ;
   subtracting bits or symbols of the second data stream from bits or symbols of the first stream to produce a third stream of digital bits or symbols; and
   accumulating the third stream of digital bits or symbols to form a fourth stream of digital bits or symbols each having one of the values 1, 0 and -1.

**Patentansprüche**

1. Schaltung zur Bestimmung eines Signals zum Anzeigen eines Verhältnisses von Frequenzen eines ersten Taktsignals (Fx) zu einem Referenztaktsignal (Fs), wobei das Referenztaktsignal (Fs) eine höhere Frequenz aufweist als die Frequenz des ersten Taktsignals (Fx), **dadurch gekennzeichnet, dass** die Schaltung umfasst:

   eine Anfangsspeicherschaltung (Q1) zum Halten des Taktsignals (Fx);
   zumindest zwei Zweige von Speicherschaltungen (Q2, Q3, Q4, Q5, Q6) in Reihe mit der Anfangsspeicherschaltung (Q1) und betriebsfähig, um zeitverzögerte Versionen des ersten Taktsignals (Fx) und zeitverzögerte Versionen der Umkehrung des ersten Taktsignals (Fx) zu halten, wobei die zumindest zwei Zweige parallel zueinander sind;
   eine Mehrzahl von mit den Speicherschaltungen gekoppelten logischen Schaltungen (N1, N2, N3), die als

**EP 1 021 885 B1**

Eingangssignal die verzögerten Versionen des ersten Taktsignals (Fx) und die verzögerten umgekehrten Versionen des ersten Taktsignals (Fx) verwenden;

ein mit zumindest einer der Mehrzahl von logischen Schaltungen (N1, N2, N3) gekoppeltes Digitalfilter, welches das Ausgangssignal der zumindest einen der Mehrzahl von logischen Schaltungen (N1, N2, N3) filtert und betriebsfähig ist, um das Signal zum Anzeigen des Verhältnisses der Frequenzen des Referenztaktsignals (Fs) zu dem ersten Taktsignal (Fx) auszugeben;

wobei zumindest eine erste Speicherschaltung unter den Speicherschaltungen in jedem der beiden Zweige durch das Referenztaktsignal (Fs) getaktet wird;

wobei zumindest eine zweite Speicherschaltung unter den Speicherschaltungen durch das erste Taktsignal (Fx) getaktet wird.

2. Die Schaltung nach Anspruch 1, wobei das Digitalfilter eine Gewichtungsfunktion nutzt, bei der auf unterschiedliche Ausgangssignale zu unterschiedlichen Zeiten der Mehrzahl von logischen Schaltungen (N1, N2, N3) unterschiedliche Wichtungen angewendet werden.

3. Die Schaltung nach Anspruch 1, weiterhin umfassend:

einen Wichtungsgenerator (WG) ;
einen ersten Akkumulator (ACC1) ; und
einen zweiten Akkumulator (ACC2) ;
wobei der erste Akkumulator (ACC1) als Eingangssignal einen Strom digitaler Bits oder Symbole empfängt, der mit dem Akkumulations- und Quantisierungsausgang einer ersten Schaltung unter der Mehrzahl von logischen Schaltungen (N1, N2, N3) assoziiert ist, und einen Ausgangsstrom von Daten oder Symbolen produziert, wobei der Wichtungsgenerator (WG) eine Reihe von Wichtungen produziert und der zweite Akkumulator (ACC2) die Reihe von Wichtungen und den Ausgangsstrom von Bits oder Symbolen von dem ersten Akkumulator (ACC1) empfängt und eine Phasenschätzung produziert.

4. Die Schaltung nach Anspruch 3, wobei der zweite Akkumulator (ACC2) einen Hardware-Multiplizierer umfasst.

5. Die Schaltung nach Anspruch 3, wobei der erste Akkumulator (ACC1) einen Referenzmustergenerator umfasst und der Ausgangsstrom aus den Symbolen 1, 0 und -1 besteht,
und wobei der zweite Akkumulator (ACC2) einen Addierer/Subtrahierer umfasst.

6. Die Schaltung nach Anspruch 1, weiterhin umfassend:

einen Wichtungsgenerator (WG) ;
einen ersten Akkumulator (ACC1) ;
einen zweiten Akkumulator (ACC2) ; und
einen Summierungsblock;
wobei der Wichtungsgenerator (WG) eine Reihe von Wichtungen generiert, der erste Akkumulator (ACC1) als Eingangssignale den Strom digitaler Bits oder Symbole von einer Mehrzahl von logischen Schaltungen und die Reihe von Wichtungen von dem Wichtungsgenerator (WG) empfängt und einen ersten Ausgangsstrom von Symbolen produziert, wobei der zweite Akkumulator (ACC2) als Eingangssignale den Strom digitaler Bits oder Symbole von dem ersten Akkumulator (ACC1) empfängt und einen zweiten Ausgangsstrom von Symbolen produziert und der Summierungsblock die Ausgangssignale des ersten Akkumulators (ACC1) und des zweiten Akkumulators (ACC2) summiert, um eine Phasenschätzung zu produzieren.

7. Verfahren zur Bestimmung eines Signals zum Anzeigen eines Verhältnisses von Frequenzen eines ersten Taktsignals (Fx) zu einem Referenztaktsignal (Fs), wobei das Referenztaktsignal (Fs) eine höhere Frequenz aufweist als die Frequenz des ersten Taktsignals (Fx), **dadurch gekennzeichnet, dass** das Verfahren die folgenden Schritte umfasst:

Halten des ersten Taktsignals (Fx) in einer Anfangsspeicherschaltung (Q1) ;
Halten zeitverzögerter Versionen des ersten Taktsignals (Fx) und zeitverzögerter Versionen der Umkehrung des ersten Taktsignals (Fx) in zumindest zwei Zweigen von Speicherschaltungen (Q2, Q3, Q4, Q5, Q6), die in Reihe mit der Anfangsspeicherschaltung (Q1) geschaltet sind, wobei die zumindest zwei Zweige parallel zueinander sind;
Bereitstellen einer Mehrzahl von mit den Speicherschaltungen (Q1, Q2, Q3, Q4, Q5, Q6) gekoppelten logischen

9

Schaltungen (N1, N2, N3), die als Eingangssignal die verzögerten Versionen des ersten Taktsignals (Fx) und die verzögerten umgekehrten Versionen des ersten Taktsignals (Fx) verwenden;

Bereitstellen von mit zumindest einer der Mehrzahl von logischen Schaltungen (N1, N2, N3) gekoppeltem Digitalfilter, welches das Ausgangssignal der zumindest einen der Mehrzahl von logischen Schaltungen (N1, N2, N3) filtert und das Signal zum Anzeigen des Verhältnisses der Frequenzen des Referenztaktsignals (Fs) zu dem ersten Taktsignal (Fx) ausgibt;

Takten zumindest einer ersten Speicherschaltung unter den Speicherschaltungen (Q2, Q3, Q4, Q5, Q6) in jedem der beiden Zweige durch das Referenztaktsignal (Fs); und

Takten zumindest einer zweiten Speicherschaltung unter den Speicherschaltungen (Q2, Q3, Q4, Q5, Q6) durch das erste Taktsignal (Fx).

8. Das Verfahren nach Anspruch 7, wobei das Generieren digitaler Daten das Filtern eines ersten Stroms digitaler Bits einer ersten logischen Schaltung (N1) unter der Mehrzahl logischer Schaltungen (N1, N2, N3) umfasst.

9. Das Verfahren nach Anspruch 8, weiterhin umfassend Berechnen einer Frequenzdifferenzphase, wobei der Schritt des Berechnens weiterhin die folgenden Schritte umfasst:

Filtern des ersten Stroms, um ein mittleres Verhältnis von Frequenzen des ersten Taktsignals zu erhalten;
Filtern des ersten Stroms, um eine Reihe von Kurzzeitschätzungen des Verhältnisses von Frequenzen des ersten Taktsignals (Fx) zu erhalten;
für jede Schätzung Berechnen einer Differenz zwischen der Schätzung und dem mittleren Verhältnis von Frequenzen und Umwandeln der Differenz in eine Phasenzunahme; und
Akkumulieren der Phasenzunahmen, um eine laufende Phasenschätzung zu produzieren.

10. Das Verfahren nach Anspruch 8 oder 9, weiterhin umfassend die folgenden Schritte:

Produzieren eines zweiten Stroms digitaler Daten oder Symbole, die sich ergeben, wenn das Referenztaktsignal (Fs) in Übereinstimmung mit dem ersten Taktsignal (Fx) abgetastet wird;
Subtrahieren von Bits oder Symbolen des zweiten Datenstroms von Bits oder Symbolen des ersten Datenstroms, um einen dritten Strom digitaler Bits oder Symbole zu produzieren; und
Akkumulieren des dritten Stroms digitaler Bits oder Symbole, um einen vierten Strom digitaler Bits oder Symbole zu bilden, die jeweils einen der Werte 1, 0 und -1 aufweisen.

## Revendications

1. Circuit pour déterminer un signal indiquant un rapport de fréquences d'un premier signal d'horloge (Fx) par un signal d'horloge de référence (Fs), le signal d'horloge de référence (Fs) ayant une fréquence supérieure à la fréquence d'un premier signal d'horloge (Fx), **caractérisé en ce que** le circuit comprend:

un circuit de stockage initial (Q1) pour maintenir le premier signal d'horloge (Fx);
au moins deux branches de circuits de stockage (Q2, Q3, Q4, Q5, Q6) en série avec le circuit de stockage initial (Q1) et pouvant être actionnées pour maintenir des versions retardées dans le temps du premier signal d'horloge (Fx) et des versions retardées dans le temps de l'inverse du premier signal d'horloge (Fx), les au moins deux branches étant parallèles l'une à l'autre;
une pluralité de circuits logiques (N1, N2, N3), couplés aux circuits de stockage, utilisant comme entrées les versions retardées du premier signal d'horloge (Fx) et les versions inversées retardées du premier signal d'horloge (Fx);
un filtre numérique couplé à au moins l'un de la pluralité de circuits logiques (N1, N2, N3), qui filtre la sortie du au moins l'un de la pluralité de circuits logiques (N1, N2, N3) et pouvant être actionné pour sortir le signal indiquant le rapport de fréquences du signal d'horloge de référence (Fs) par le premier signal d'horloge (Fx);
où au moins un premier circuit de stockage parmi les circuits de stockage, dans chacune des deux branches, est réglé au temps d'horloge par le signal d'horloge de référence (Fs);
où au moins un deuxième circuit de stockage parmi les circuits de stockage est réglé au temps d'horloge par le premier signal d'horloge (Fx).

2. Circuit de la revendication 1, dans lequel le filtre numérique emploie une fonction de pondération dans laquelle différents poids sont appliqués à différentes sorties à différents moments de la pluralité de circuits logiques (N1, N2, N3).

3. Circuit de la revendication 1, comprenant en plus:

un générateur de poids (WG);
un premier accumulateur (ACC1); et
un deuxième accumulateur (ACC2);
où le premier accumulateur (ACC1) reçoit comme une entrée un train de symboles ou de bits numériques associés à l'accumulation et quantification sortis depuis un premier circuit parmi la pluralité de circuits logiques (N1, N2, N3) et produit un train de sortie de bits ou de symboles, le générateur de poids (WG) produit une série de poids, et le deuxième accumulateur (ACC2) reçoit la série de poids et le train de sortie de bits ou de symboles depuis le premier accumulateur (ACC1) et produit une estimation de phase.

4. Circuit de la revendication 3, dans lequel le deuxième accumulateur (ACC2) comprend un multiplicateur matériel.

5. Circuit de la revendication 3, dans lequel ledit premier accumulateur (ACC1) comprend un générateur de modèles de référence et ledit train de sortie consiste en les symboles 1, 0 et -1,
et où ledit deuxième accumulateur (ACC2) comprend un additionneur/soustracteur.

6. Circuit de la revendication 1, comprenant en plus:

un générateur de poids (WG);
un premier accumulateur (ACC1);
un deuxième accumulateur (ACC2); et
un bloc de sommation;
où le générateur de poids (WG) produit une série de poids, le premier accumulateur (ACC1) reçoit comme entrées le train de symboles ou de bits numériques depuis une pluralité de circuits logiques et la série de poids depuis le générateur de poids (WG) et produit un premier train de sortie de symboles, le deuxième accumulateur (ACC2) reçoit comme entrées le train de symboles ou de bits numériques depuis le premier accumulateur (ACC1) et produit un deuxième train de sortie de symboles, et le bloc de sommation fait une somme de sorties depuis le premier accumulateur (ACC1) et le deuxième accumulateur (ACC2) pour produire une estimation de phase.

7. Procédé pour déterminer un signal indiquant un rapport de fréquences d'un premier signal d'horloge (Fx) par un signal d'horloge de référence (Fs), le signal d'horloge de référence (Fs) ayant une fréquence supérieure à la fréquence du premier signal d'horloge (Fx), **caractérisé en ce que** le procédé comprend les étapes de:

maintenir le premier signal d'horloge (Fx) dans un circuit de stockage initial (Q1);
maintenir des versions retardées dans le temps du premier signal d'horloge (Fx) et des versions retardées dans le temps de l'inverse du premier signal d'horloge (Fx) dans au moins deux branches de circuits de stockage (Q2, Q3, Q4, Q5, Q6) qui sont en série avec le circuit de stockage initial (Q1), les au moins deux branches étant parallèles l'une à l'autre;
fournir une pluralité de circuits logiques (N1, N2, N3), couplés aux circuits de stockage (Q1, Q2, Q3, Q4, Q5, Q6), qui utilisent comme entrée les versions retardées du premier signal d'horloge (Fx) et les versions inversées retardées du premier signal d'horloge (Fx);
fournir un filtre numérique couplé à au moins l'un de la pluralité de circuits logiques (N1, N2, N3), qui filtre la sortie du au moins l'un de la pluralité de circuits logiques (N1, N2, N3) et sort le signal indiquant le rapport de fréquences du signal d'horloge de référence (Fs) par le premier signal d'horloge (Fx);
régler au temps d'horloge au moins un premier circuit de stockage parmi les circuits de stockage (Q2, Q3, Q4, Q5, Q6), dans chacune des deux branches, par le signal d'horloge de référence (Fs); et
régler au temps d'horloge au moins un deuxième circuit de stockage parmi les circuits de stockage (Q2, Q3, Q4, Q5, Q6) par le premier signal d'horloge (Fx).

8. Procédé de la revendication 7, dans lequel le fait de générer des données numériques comprend le fait de filtrer un premier train de bits numériques à partir d'un premier circuit logique (N1) parmi la pluralité de circuits logiques (N1, N2, N3).

9. Procédé de la revendication 8, comprenant en plus le fait de calculer une phase de différence de fréquences, l'étape de calcul comprenant en plus les étapes de:

filtrer le premier train pour obtenir un rapport moyen de fréquences des premiers signaux d'horloge;
filtrer le premier train pour obtenir une série d'estimations à court terme du rapport de fréquences des premiers signaux d'horloge (Fx);
pour chaque estimation, calculer une différence entre l'estimation et le rapport moyen de fréquences et convertir la différence en un incrément de phase; et
accumuler les incréments de phases pour produire une estimation de phase glissante.

**10.** Procédé de la revendication 8 ou 9, comprenant en plus les étapes de:

produire un deuxième train de symboles ou de bits numériques qui résultent lorsque le signal d'horloge de référence (Fs) est échantillonné en conformité avec le premier signal d'horloge (Fx);
soustraire des bits ou des symboles du deuxième train de données de bits ou de symboles du premier train pour produire un troisième train de symboles ou de bits numériques; et
accumuler le troisième train de symboles ou de bits numériques pour former un quatrième train de symboles ou de bits numériques ayant chacun l'une des valeurs 1, 0 et -1.

| Accumulator $G_n = G_{n-1} + 0.6875 - INT(G_{n-1})$ | Data Stream $R_n = INT(G_n)$ |
|---|---|
| 0.6875 | 0 |
| 1.375 | 1 |
| 1.0625 | 1 |
| 0.75 | 0 |
| 1.4375 | 1 |
| 1.125 | 1 |
| 0.8125 | 0 |
| 1.5 | 1 |
| 1.1875 | 1 |
| 0.875 | 0 |
| 1.5625 | 1 |
| 1.25 | 1 |
| 0.9375 | 0 |
| 1.625 | 1 |
| 1.3125 | 1 |
| 1 | 1 |
| 0.6875 | 0 |

*FIG. 2*

ACCUMULATION    QUANTIZATION

*FIG. 1*

*FIG. 3*

1.0    1.3125    1.625    0.9375    1.25    1.5625    0.875    1.1875    1.5    0.8125    1.125    1.4375    0.75    1.0625    1.375    0.6875

Extra Stage(s) may
be needed to minimize
metastability

These two sections
must be carefully
matched to
minimize errors

Fig. 4

EP 1 021 885 B1

**FIG. 5**

**FIG. 6**

FIG. 7

FIG. 8

FIG. 9

FIG. 10

Fs

107

Carry
FF

101

Count Down

7 Bit Counter
(count to 127
and stop)

Terminal Count

LSB

1

Oversampled Data Stream X → Add Carry In

Σ

103

14 Bit Register

105

Accumulate
for 256
Clocks

R X 128 X 129
Estimator for
Frequency Ratio

EP 1 021 885 B1

| Observed Frequency Data Stream X | Weight W | Fr Ratio = Reference Frequency/ Sample Frequency = |
|---|---|---|
| 1 | 1 | 0.6875 |
| 1 | 2 | |
| 0 | 3 | |
| 1 | 4 | |
| 1 | 5 | |
| 0 | 6 | |
| 1 | 7 | |
| 1 | 8 | |
| 0 | 9 | |
| 1 | 10 | |
| 1 | 11 | |
| 1 | 12 | |
| 0 | 13 | |
| 1 | 14 | |
| 1 | 15 | |
| 0 | 16 | |
| 1 | 17 | |
| 1 | 18 | |
| 0 | 19 | |
| 1 | 20 | |
| 1 | 21 | |
| 0 | 22 | |
| 1 | 23 | |
| 1 | 24 | |
| 0 | 25 | |
| 1 | 26 | |
| 1 | 27 | |
| 1 | 28 | |
| 0 | 29 | |
| 1 | 30 | |
| 1 | 31 | |
| 0 | 32 | |
| 1 | 33 | |
| 1 | 34 | |
| 0 | 35 | |
| 1 | 36 | |
| 1 | 37 | |
| 0 | 38 | |
| 1 | 39 | |
| 1 | 40 | |
| 0 | 41 | |
| 1 | 42 | |
| 1 | 43 | |

*FIG. 11A-1*

FIG. 11A-1

FIG. 11A-2

*FIG. 11A*

| | |
|---|---|
| 0 | 44 |
| 1 | 45 |
| 1 | 46 |
| 1 | 47 |
| 0 | 48 |
| 1 | 49 |
| 1 | 50 |
| 0 | 51 |
| 1 | 52 |
| 1 | 53 |
| 0 | 54 |
| 1 | 55 |
| 1 | 56 |
| 0 | 57 |
| 1 | 58 |
| 1 | 59 |
| 0 | 60 |
| 1 | 61 |
| 1 | 62 |
| 1 | 63 |
| 0 | 64 |

| | | | Frequency Estimate | | Integration |
|---|---|---|---|---|---|
| | Correct Phase | | $F_n = \sum_i (W_i * X_{i+n})$ F | $\Delta F_i = F_i - Fr$ Ratio $\Delta F$ | $PF_n = PF_{n-1} * k * \Delta F_i$ Pf |
| 1 | 64 | | $-53.714763$ | $0.686058$ | $-0.001442$ | $-55.876923$ |
| 1 | 63 | | $-54.394811$ | $0.686058$ | $-0.001442$ | $-56.615385$ |
| 0 | 62 | | $-55.066978$ | $0.686058$ | $-0.001442$ | $-57.353846$ |
| 1 | 61 | | $-55.731139$ | $0.686058$ | $-0.001442$ | $-58.092308$ |
| 1 | 60 | | $-56.387171$ | $0.686058$ | $-0.001442$ | $-58.830769$ |
| 0 | 59 | | $-57.034949$ | $0.686058$ | $-0.001442$ | $-59.569231$ |
| 1 | 58 | | $-57.674350$ | $0.686058$ | $-0.001442$ | $-60.307692$ |

# FIG. 11A-2

**FIG. 11B**

Ave Error=1.501453

**FIG. 11C**

| Observed Frequency Data Stream X | Weight W | $Y_i = X_i - FrRatio$ Y | $PX_i = PX_{i-1} + Y_i$ Px | Fr Ratio = Reference Frequency/ Sample Frequency = 0.6875 |
|---|---|---|---|---|
| 1 | 1 | 0.3125 | 0.0000 | |
| 1 | 2 | 0.3125 | 0.3125 | |
| 0 | 3 | −0.6875 | −0.3750 | |
| 1 | 4 | 0.3125 | −0.0625 | |
| 1 | 5 | 0.3125 | 0.2500 | |
| 0 | 6 | −0.6875 | −0.4375 | |
| 1 | 7 | 0.3125 | −0.1250 | |
| 1 | 8 | 0.3125 | 0.1875 | |
| 0 | 9 | −0.6875 | −0.5000 | |
| 1 | 10 | 0.3125 | −0.1875 | |
| 1 | 11 | 0.3125 | 0.1250 | |
| 1 | 12 | 0.3125 | 0.4375 | |
| 0 | 13 | −0.6875 | −0.2500 | |
| 1 | 14 | 0.3125 | 0.0625 | |
| 1 | 15 | 0.3125 | 0.3750 | |
| 0 | 16 | −0.6875 | −0.3125 | |
| 1 | 17 | 0.3125 | 0.0000 | |
| 1 | 18 | 0.3125 | 0.3125 | |
| 0 | 19 | −0.6875 | −0.3750 | |
| 1 | 20 | 0.3125 | −0.0625 | |
| 1 | 21 | 0.3125 | 0.2500 | |
| 0 | 22 | −0.6875 | −0.4375 | |
| 1 | 23 | 0.3125 | −0.1250 | |
| 1 | 24 | 0.3125 | 0.1875 | |
| 0 | 25 | −0.6875 | −0.5000 | |
| 1 | 26 | 0.3125 | −0.1875 | |
| 1 | 27 | 0.3125 | 0.1250 | |
| 1 | 28 | 0.3125 | 0.4375 | |
| 0 | 29 | −0.6875 | −0.2500 | |
| 1 | 30 | 0.3125 | 0.0625 | |
| 1 | 31 | 0.3125 | 0.3750 | |
| 0 | 32 | −0.6875 | −0.3125 | |
| 1 | 33 | 0.3125 | 0.0000 | |
| 1 | 34 | 0.3125 | 0.3125 | |
| 0 | 35 | −0.6875 | −0.3750 | |
| 1 | 36 | 0.3125 | −0.0625 | |
| 1 | 37 | 0.3125 | 0.2500 | |
| 0 | 38 | −0.6875 | −0.4375 | |
| 1 | 39 | 0.3125 | −0.1250 | |
| 1 | 40 | 0.3125 | 0.1875 | |
| 0 | 41 | −0.6875 | −0.5000 | |
| 1 | 42 | 0.3125 | −0.1875 | |
| 1 | 43 | 0.3125 | 0.1250 | |

**FIG. 12A-1**

| FIG. 12A-1 |
|---|
| FIG. 12A-2 |

**FIG. 12A**

| | | | | Correct Phase | $PP_n = k* \sum_i (W_i + PX_{i+n})$ PP |
|---|---|---|---|---|---|
| 0 | 44 | −0.6875 | −0.5625 | | |
| .1 | 45 | 0.3125 | −0.2500 | | |
| 1 | 46 | 0.3125 | 0.0625 | | |
| 1 | 47 | 0.3125 | 0.3750 | | |
| 0 | 48 | −0.6875 | −0.3125 | | |
| 1 | 49 | 0.3125 | 0.0000 | | |
| 1 | 50 | 0.3125 | 0.3125 | | |
| 0 | 51 | −0.6875 | −0.3750 | | |
| 1 | 52 | 0.3125 | −0.0625 | | |
| 1 | 53 | 0.3125 | 0.2500 | | |
| 0 | 54 | −0.6875 | −0.4375 | | |
| 1 | 55 | 0.3125 | −0.1250 | | |
| 1 | 56 | 0.3125 | 0.1875 | | |
| 0 | 57 | −0.6875 | −0.5000 | | |
| 1 | 58 | 0.3125 | −0.1875 | | |
| 1 | 59 | 0.3125 | 0.1250 | | |
| 0 | 60 | −0.6875 | −0.5625 | | |
| 1 | 61 | 0.3125 | −0.2500 | | |
| 1 | 62 | 0.3125 | 0.0625 | | |
| 1 | 63 | 0.3125 | 0.3750 | | |
| 0 | 64 | −0.6875 | −0.3125 | | |
| 1 | 64 | 0.3125 | 0.0000 | −53.714763 | −55.876923 |
| 1 | 63 | 0.3125 | 0.3125 | −54.394811 | −56.615385 |
| 0 | 62 | −0.6875 | −0.3750 | −55.066976 | −57.353846 |
| 1 | 61 | 0.3125 | −0.0625 | −55.731139 | −58.092308 |
| 1 | 60 | 0.3125 | 0.2500 | −56.387171 | −58.830769 |
| 0 | 59 | −0.6875 | −0.4376 | −57.034949 | −59.569231 |
| 1 | 58 | 0.3125 | −0.1250 | −57.674350 | −60.307692 |

## FIG. 12A-2

**FIG. 12B**

Ave Error= 1.501453

**FIG. 12C**

**FIG. 13**

| Reference Frequency Data Stream R | Observed Frequency Data System X | $D_i = D_{i-1} + X_i - Ri$ D | Weight W | Fr Ratio= Reference Frequency/ Sample Frequency = 0.6875 |
|---|---|---|---|---|
| 1 | 1 | 0 | 1 | |
| 1 | 1 | 0 | 2 | |
| 0 | 0 | 0 | 3 | |
| 1 | 1 | 0 | 4 | |
| 1 | 1 | 0 | 5 | |
| 0 | 0 | 0 | 6 | |
| 1 | 1 | 0 | 7 | |
| 1 | 1 | 0 | 8 | |
| 1 | 0 | −1 | 9 | |
| 0 | 1 | 0 | 10 | |
| 1 | 1 | 0 | 11 | |
| 1 | 1 | 0 | 12 | |
| 0 | 0 | 0 | 13 | |
| 1 | 1 | 0 | 14 | |
| 1 | 1 | 0 | 15 | |
| 0 | 0 | 0 | 16 | |
| 1 | 1 | 0 | 17 | |
| 1 | 1 | 0 | 18 | |
| 0 | 0 | 0 | 19 | |
| 1 | 1 | 0 | 20 | |
| 1 | 1 | 0 | 21 | |
| 0 | 0 | 0 | 22 | |
| 1 | 1 | 0 | 23 | |
| 1 | 1 | 0 | 24 | |
| 1 | 0 | −1 | 25 | |
| 0 | 1 | 0 | 26 | |
| 1 | 1 | 0 | 27 | |
| 1 | 1 | 0 | 28 | |
| 0 | 0 | 0 | 29 | |
| 1 | 1 | 0 | 30 | |
| 1 | 1 | 0 | 31 | |
| 0 | 0 | 0 | 32 | |
| 1 | 1 | 0 | 33 | |
| 1 | 1 | 0 | 34 | |
| 0 | 0 | 0 | 35 | |
| 1 | 1 | 0 | 36 | |
| 1 | 1 | 0 | 37 | |
| 0 | 0 | 0 | 38 | |
| 1 | 1 | 0 | 39 | |
| 1 | 1 | 0 | 40 | |
| 1 | 0 | −1 | 41 | |
| 0 | 1 | 0 | 42 | |

**FIG. 14A-1**

| |
|---|
| FIG. 14A-1 |
| FIG. 14A-2 |

**FIG. 14A**

| | | | | | Correct Phase | $PI_n=$ $k_0+k_1*\sum_i(W_i*D_{i+n})$ F |
|---|---|---|---|---|---|---|
| 1 | 1 | 0 | 43 | | | |
| 1 | 0 | −1 | 44 | | | |
| 0 | 1 | 0 | 45 | | | |
| 1 | 1 | 0 | 46 | | | |
| 1 | 1 | 0 | 47 | | | |
| 0 | 0 | 0 | 48 | | | |
| 1 | 1 | 0 | 49 | | | |
| 1 | 1 | 0 | 50 | | | |
| 0 | 0 | 0 | 51 | | | |
| 1 | 1 | 0 | 52 | | | |
| 1 | 1 | 0 | 53 | | | |
| 0 | 0 | 0 | 54 | | | |
| 1 | 1 | 0 | 55 | | | |
| 1 | 1 | 0 | 56 | | | |
| 1 | 0 | −1 | 57 | | | |
| 0 | 1 | 0 | 58 | | | |
| 1 | 1 | 0 | 59 | | | |
| 1 | 0 | −1 | 60 | | | |
| 0 | 1 | 0 | 61 | | | |
| 1 | 1 | 0 | 62 | | | |
| 1 | 1 | 0 | 63 | | | |
| 0 | 0 | 0 | 64 | | | |
| 1 | 1 | 0 | 64 | −53.714763 | −55.876923 | |
| 1 | 1 | 0 | 63 | −54.394811 | −56.615385 | |
| 0 | 0 | 0 | 62 | −55.066978 | −57.353846 | |
| 1 | 1 | 0 | 61 | −55.731139 | −58.092308 | |
| 1 | 1 | 0 | 60 | −56.387171 | −58.830769 | |
| 0 | 0 | 0 | 59 | −57.034949 | −59.569231 | |
| 1 | 1 | 0 | 58 | −57.674350 | −60.307692 | |

$k_0 = 16$

## FIG. 14A-2

28

FIG. 14B

Ave Error= 1.501453

FIG. 14C

FIG. 15

| Reference Frequency Generator RG | Reference Frequency Data Stream R | Observed Frequency Data System X | $D_i = D_{i-1} + X_i - Ri$ D | Weight W | Fr Ratio= Reference Frequency/ Sample Frequency = 0.6875 |
|---|---|---|---|---|---|
| 1.5 | 1 | 1 | 0 | −0.5 | |
| 1.1875 | 1 | 1 | 0 | −2 | |
| 0.875 | 0 | 0 | 0 | −4.5 | |
| 1.5625 | 1 | 1 | 0 | −8 | |
| 1.25 | 1 | 1 | 0 | −12.5 | |
| 0.9375 | 0 | 0 | 0 | −18 | |
| 1.625 | 1 | 1 | 0 | −24.5 | |
| 1.3125 | 1 | 1 | 0 | −32 | |
| 1 | 1 | 0 | −1 | −40.5 | |
| 0.6675 | 0 | 1 | 0 | −50 | |
| 1.375 | 1 | 1 | 0 | −60.5 | |
| 1.0625 | 1 | 1 | 0 | −72 | |
| 0.75 | 0 | 0 | 0 | −84.5 | |
| 1.4375 | 1 | 1 | 0 | −98 | |
| 1.125 | 1 | 1 | 0 | −112.5 | |
| 0.8125 | 0 | 0 | 0 | −128 | |
| 1.5 | 1 | 1 | 0 | −144.5 | |
| 1.1875 | 1 | 1 | 0 | −162 | |
| 0.875 | 0 | 0 | 0 | −180.5 | |
| 1.5625 | 1 | 1 | 0 | −200 | |
| 1.25 | 1 | 1 | 0 | −220.5 | |
| 0.9375 | 0 | 0 | 0 | −242 | |
| 1.625 | 1 | 1 | 0 | −264.5 | |
| 1.3125 | 1 | 1 | 0 | −288 | |
| 1 | 1 | 0 | −1 | −312.5 | |
| 0.6875 | 0 | 1 | 0 | −338 | |
| 1.375 | 1 | 1 | 0 | −364.5 | |
| 1.0625 | 1 | 1 | 0 | −392 | |
| 0.75 | 0 | 0 | 0 | −420.5 | |
| 1.4375 | 1 | 1 | 0 | −450 | |
| 1.125 | 1 | 1 | 0 | −480.5 | |
| 0.8125 | 0 | 0 | 0 | −512 | |
| 1.5 | 1 | 1 | 0 | −644.5 | |
| 1.1875 | 1 | 1 | 0 | −578 | |
| 0.875 | 0 | 0 | 0 | −612.5 | |
| 1.5625 | 1 | 1 | 0 | −648 | |
| 1.25 | 1 | 1 | 0 | −684.5 | |
| 0.9375 | 0 | 0 | 0 | −722 | |
| 1.625 | 1 | 1 | 0 | −760.6 | |
| 1.3125 | 1 | 1 | 0 | −800 | |
| 1 | 1 | 0 | −1 | −840.5 | |
| 0.6875 | 0 | 1 | 0 | 882 | |

FIG. 16A-1

FIG. 16A-2

FIG. 16A

FIG. 16A-1

EP 1 021 885 B1

| | | | | | Correct Phase | $PC_n = k*(D_n - frac(RG_n)+0.5+\sum_i(W_i * X_{i+n-64}))$ PC |
|---|---|---|---|---|---|---|
| 1.375 | 1 | 1 | 0 | −924.5 | | |
| 1.0625 | 1 | 0 | −1 | −968 | | |
| 0.75 | 0 | 1 | 0 | −1012.5 | | |
| 1.4375 | 1 | 1 | 0 | −1068 | | |
| 1.125 | 1 | 1 | 0 | −1104.5 | | |
| 0.8125 | 0 | 0 | 0 | −1152 | | |
| 1.5 | 1 | 1 | 0 | −1200.5 | | |
| 1.1875 | 1 | 1 | 0 | −1250 | | |
| 0.875 | 0 | 0 | 0 | −1300.5 | | |
| 1.5625 | 1 | 1 | 0 | −1352 | | |
| 1.25 | 1 | 1 | 0 | −1404.5 | | |
| 0.9375 | 0 | 0 | 0 | −1458 | | |
| 1.625 | 1 | 1 | 0 | −1512.5 | | |
| 1.3125 | 1 | 1 | 0 | −1568 | | |
| 1 | 1 | 0 | −1 | −1624.5 | | |
| 0.6875 | 0 | 1 | 0 | −1682 | | |
| 1.375 | 1 | 1 | 0 | −1740.5 | | |
| 1.0625 | 1 | 0 | −1 | −1800 | | |
| 0.75 | 0 | 1 | 0 | −1860.5 | | |
| 1.4375 | 1 | 1 | 0 | −1922 | | |
| 1.125 | 1 | 1 | 0 | −1984.5 | | |
| 0.8125 | 0 | 0 | 0 | −2048 | | |
| 1.5 | 1 | 1 | 0 | 2048 | −53.374738 | −55.507692 |
| 1.1875 | 1 | 1 | 0 | 1984.5 | −54.054787 | −56.246154 |
| 0.875 | 0 | 0 | 0 | 1922 | −54.730895 | −56.984615 |
| 1.5625 | 1 | 1 | 0 | 1860.5 | −55.399059 | −57.723077 |
| 1.25 | 1 | 1 | 0 | 1800 | −56.059155 | −58.461538 |
| 0.9375 | 0 | 0 | 0 | 1740.5 | −56.711060 | −59.200000 |
| 1.625 | 1 | 1 | 0 | 1682 | −57.354650 | −59.938462 |
| 1.3125 | 1 | 1 | 0 | 1624.5 | −57.939800 | −60.676923 |

**FIG. 16A-2**

**FIG. 16B**

Ave Error= 1.501476

**FIG. 16C**

FIG. 17

EP 1 021 885 B1

**EP 1 021 885 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5084669 A
- US 5664165 A
- US 5557647 A

### Non-patent literature cited in the description

- **CANDY et al.** Oversampling Delta-Sigma Data Converters. IEEE Press, 1992, 1-6